# EUROPEAN PATENT APPLICATION

(11) **EP 4 287 231 A1**
(43) Date of publication of application: **06.12.2023**
(21) Application number: 22746179.5
(22) Date of filing: 24.01.2022
(51) Int. Cl.: H01H 9/54, B60L 53/24, B60L 53/18, B60L 53/16, H02M 7/08, H02M 3/00

(54) **MULTIPLE CONNECTION SWITCH, AND CHARGING LOCATION-SELECTIVE ELECTRIC VEHICLE CHARGING SYSTEM COMPRISING SAME**

(30) Priority: 26.01.2021 KR 20210010613; 20.08.2021 KR 20210110406; 23.09.2021 KR 20210125616
(71) Applicant: Fec Co., Ltd., Gyeongsan-si, Gyeongsangbuk-do 38498 (KR)
(72) Inventor: LEE, Sang Hwa, Seoul 06299 (KR); LEE, Yoon Won, Seoul 06299 (KR); LEE, Kyung Jin, Seongnam-si Gyeonggi-do 13611 (KR)
(74) Representative: Samson & Partner Patentanwälte mbB
(86) International application number: PCT/KR2022/001218
(87) International publication number: WO 2022/164152

(57) **Abstract**

An electric vehicle charging system according to one aspect of the present invention operates a multi-connection switch connected to three or more electric wires of an electrical grid, so as to connect some electric wires from among the three or more electric wires, and thus can selectively form connection paths. The multi-connection switch comprises: multiple directional contacts that enable, through longitudinal conductors, the incoming and outgoing of electricity and are connected from the outside; internal wirings formed as longitudinal conductors that mutually connect the contacts; one or more switches provided in the corresponding internal wirings to perform the role of connecting or disconnecting any one part of the internal wirings; and a control unit capable of turning the switches on or off.

## Description

### Technical Field

The present disclosure relates to a charging system for an electric vehicle, which is capable of fixed charging or variable charging by using DC power and, more particularly, to a technology for forming a path along which an electric vehicle is charged by using multi-connection switches.

### Background Art

Conventionally, when an electric vehicle is charged, AC power is connected up to a charger. The charger supplies the electric vehicle with AC power in the case of slow charging, and supplies the electric vehicle with DC power by converting AC power into DC power in the case of quick charging.

Accordingly, since kiosk must be installed around a parking space in order to charge the electric vehicle, a separate kiosk installation space is required and the electric vehicle can be charged at a location where kiosk has been installed.

If a parking space dedicated to electric vehicles is increased for the charging of many electric vehicles, there are problems in that an installation cost for kiosk is increased and a wide space is required.

Furthermore, the electric vehicle needs to be immediately moved to another place after being charged. Furthermore, a vehicle to be charged, which waits its turn, has to enter a charging location and to be prepared for its charging. In most of problems in charging, a competition and inefficiency occur in such a process.

### DISCLOSURE

### Technical Problem

The present disclosure has been proposed in order to solve the problems of a conventional technology.

Specifically, one of core objects of the present disclosure is to construct a charging system by using a transformer, an AC/DC converting system, a request power manipulation unit, a relay connection power grid, and an intra-parking lot power grid, and to supply charging power to an electric vehicle via a relay connection power grid within a building and the intra-parking lot power grid by installing the transformer, the AC/DC converting system, and the request power manipulation unit at a specific place inside or outside the building.

Furthermore, in an object of the present disclosure, the request power manipulation unit may select and transmit power approximate to a charging speed, based on the charging speed requested by a charging wisher, or may provide the power by changing or combining the power into as corresponding power. Charging power is provided so that charging is possible at any parking space through the relay connection grid and the intra-parking lot power grid.

Furthermore, in an object of the present disclosure, one or more of the transformer, the AC/DC converting system, and the request power manipulation unit are installed in a space that is separated from a charging adapter 5015 in a parking zone. There is provided a parking space in which the number of charging adapters 5015 is greater than the number of DC/DC converters.

Furthermore, in an object of the present disclosure, the request power manipulation unit may select and transmit power approximate to a charging speed, based on the charging speed requested by a charging wisher, or may provide the power by changing or combining the power into as corresponding power. Charging power is provided so that charging is possible at any parking space through the intra-parking lot power grid.

Furthermore, since the number of chargeable parking zones is much greater than a small number of simultaneously charging vehicles, a concept is sought in which any D/D can be connected with an adapter in any parking zone is possible without being limited to a specific parking zone. Such an aspect may be significantly limited according to circumstances, but the present disclosure seeks such a concept in principle.

In other words, one core characteristic of the present disclosure is a parking space having the charging adapter 5015 the number of which is greater than the number of simultaneously chargeable electric vehicles. Preferably, almost all of parking spaces are designed to have the charging adapter 5015 or designed to have the charging adapter 5015 in the future. For example, the number of simultaneously chargeable electric vehicles may be 60 but the number of parking spaces including the charging adapter 5015 may be 500. In such a case, an internal combustion engine vehicle or an electric vehicle can be arbitrarily parked at the parking space regardless of the internal combustion engine vehicle or the electric vehicle. The electric vehicle does not need to be moved from the parking space although the electric vehicle has been fully charged.

Technical objects to be achieved by the present disclosure are not limited to the aforementioned objects, and the other objects not described above may be evidently understood from the following description by a person having ordinary knowledge in the art.

### Technical Solution

A charging system for an electric vehicle according to the present disclosure selectively forms a charging path up to an electric vehicle by using a multi-connection switch.

A charging system for an electric vehicle according to the present disclosure includes a control unit configured to manage overall systems; an AC/DC converting system configured to primarily convert power input from a transformer into DC power; and a DC power delivery system configured to stabilize power and determine a charging speed by receiving the DC power and to supply charging power up to an electric vehicle.

A charging system for an electric vehicle according to an embodiment of the present disclosure includes an AC/DC converting system configured to convert AC power into DC power; a request power manipulation unit comprising DC/DC converters connected to an output stage of the AC/DC converting system and an open circuit connection switch connected to an output stage of each of the DC/DC converters; charging adapters installed in at least some of parking spaces of a parking lot; a power grid configured to connect the DC/DC converters and the charging adapters between the DC/DC converters and the charging adapters; and a multi-connection switch connected to three or more electric wires of the power grid and configured to selectively form a connection path by connecting some electric wires, among the three or more electric wires.

A charging system for an electric vehicle according to an embodiment of the present disclosure may include the multi-connection switch in a plural number.

The DC/DC converter, the power grid, and a charging adapter connected to an electric vehicle, among the charging adapters, are connected to the connection path that has been selectively formed, according to an operation of the multi-connection switch.

The multi-connection switch may include sockets connected to different electrical wires; internal wirings connecting the sockets; a plurality of switches disposed in at least some of the internal wirings; and a controller configured to selectively form one or more connection paths along which two of the plurality of electric wires are connected by operating the plurality of switches.

Furthermore, the multi-connection switch may form two connection paths that are not overlapped. The two connection paths may be connected to different DC/DC converters.

The request power manipulation unit includes a plurality of first DC/DC converters and a plurality of second DC/DC converters which may be connected in parallel to the plurality of first DC/DC converters. The two connection paths may include a connection path that is connected to one of the plurality of first DC/DC converters and a connection path that is connected to one of the plurality of second DC/DC converters.

Furthermore, the three internal wirings may be connected to each of the electrical wires.

Furthermore, two switches may be disposed between two sockets.

The multi-connection switch may further include a plurality of demultiplexers connected to the plurality of switches by a control line and configured to operate the switches under the control of the controller.

Furthermore, one switch may be disposed between two sockets.

The multi-connection switch may further include a plurality of demultiplexers connected to the plurality of switches by a control line and configured to operate the switches under the control of the controller.

Furthermore, the plurality of switches and the controller may be connected by the control line.

The multi-connection switch may further include an LED for displaying a connection path.

The LED may be provided in a number corresponding to the plurality of switches.

The multi-connection switch may further include a communication line which transmits and receives signals to and from a main control apparatus.

### Advantageous Effects

One of important characteristics of the present disclosure is that the charging system including the transformer 1000, the allowed power quantity management apparatus 1100, the AC/DC converting system 2000, and the request power manipulation unit 3000 may be installed in a separate space at a front end thereof apart from the charging adapter 5015 in a parking zone.

Furthermore, there is an important characteristic in a charging method by DC by collectively converting AC into DC in a separate zone different from a space in which at least the charging adapter 5015 is present.

Furthermore, since the number of chargeable parking zones is much greater than a small number of simultaneously charging vehicles, a concept in which any D/D can be connected to an adapter in any parking zone without being limited to a specific parking zone is sought. Such an aspect may be significantly limited according to circumstances, but the present disclosure seeks such a concept in principle.

In other words, another core characteristic of the present disclosure is that a parking space includes the charging adapter 5015 the number of which is much greater than the number of simultaneously chargeable electric vehicles. Preferably, almost all of parking spaces are designed to have the charging adapter 5015 or designed to have the charging adapter 5015 in the future. For example, the number of simultaneously chargeable electric vehicles may be 60 but the number of parking spaces including the charging adapter 5015 may be 500. In such a case, an internal combustion engine vehicle or an electric vehicle can be arbitrarily parked at the parking space regardless of the internal combustion engine vehicle or the electric vehicle. The electric vehicle does not need to be moved from the parking space although the electric vehicle has been fully charged.

Furthermore, a designated parking space may be set. Although an internal combustion engine vehicle is now used or an internal combustion engine vehicle is changed into an electric vehicle in the future, the same parking space can be used without any inconvenience.

Furthermore, there is an effect in that various charging speeds can be provided in a way that the current variable DC/DC converter of the request power manipulation unit varies an output current based on a requested charging speed of a charging wisher or a current fixed type DC/DC converter similar to a charging speed provides a charging speed through a combination of output or current fixed type DC/DC converters.

Furthermore, there is an advantage in that slow charging to quick charging using DC power can be provided depending on a construction of the DC/DC converter because various charging speeds can be provided.

Furthermore, since DC power is used as main use power, there are effects in that efficiency is high because a power loss is small compared to a case in which AC power is used and a cost can be reduced by using a thin electrical wire because a current that flows into the electrical wire is low compared to the same power.

Furthermore, there are effects in that a space necessary for charging can be reduced and a cost can be reduced compared to the installation of kiosk because charging is possible in any space in which an intra-parking lot power grid has been formed without the installation of a separate large kiosk as in a conventional technology.

Furthermore, there is an advantage in that an internal combustion engine vehicle can be charged in all parking spaces in which an intra-parking lot power grid has been installed without moving the internal combustion engine vehicle that has been parked, in addition to charging only around kiosk as in a conventional technology.

### Brief Description of Drawings

FIG. 1 is a diagram illustrating a general block diagram of a system according to an embodiment of the present disclosure.
FIG. 2 is a diagram illustrating a detailed system construction diagram (a) illustrating a detailed construction of a system in which an AC/DC converting system and a request power manipulation unit according to an embodiment of the present disclosure are independently constructed, the AC/DC converting system and the request power manipulation unit are disposed inside and outside the vicinity of a parking lot, the request power manipulation unit and an intra-parking lot power grid are connected by a relay connection power grid.
FIG. 3A is a diagram illustrating a detailed system construction diagram (a) illustrating a detailed construction of a system in which the AC/DC converting system and the request power manipulation unit according to an embodiment of the present disclosure are independently constructed and the AC/DC converting system and the request power manipulation unit are present outside the vicinity of a parking lot.
FIG. 3B is a diagram illustrating a detailed system construction diagram (b) illustrating a detailed construction of a system in which the AC/DC converting system and the request power manipulation unit according to an embodiment of the present disclosure are independently constructed, several request power manipulation units are constructed in one AC/DC converting system, each request power manipulation unit can deliver power, and the AC/DC converting system and the request power manipulation unit are present outside the vicinity of a parking lot.
FIG. 3C is a diagram illustrating a detailed system construction diagram (c) illustrating a detailed construction of a system in which the AC/DC converting system and the request power manipulation unit according to an embodiment of the present disclosure are independently constructed, several request power manipulation units are separately constructed in one AC/DC converting system, and the AC/DC converting system and the request power manipulation unit are present outside the vicinity of a parking lot.
FIG. 3D is another embodiment of the present disclosure, and is a diagram illustrating a detailed system construction diagram (d) illustrating a detailed construction of a system in which the AC/DC converting system and the request power manipulation unit according to an embodiment are independently constructed, the AC/DC converting system, the request power manipulation unit, and the relay connection power grid are present outside the vicinity of a parking lot, and the intra-parking lot power grid are constructed without a separate multi-connection switch.
FIG. 4A is a diagram illustrating a multi-connection switch "a", that is, an example of an implementation of the multi-connection switch in which the number of switches is greater than the number of paths according to an embodiment of the present disclosure.
FIG. 4B is a diagram illustrating a multi-connection switch "b", that is, an example of a multi-connection switch structure in which the number of switches and the number of paths are the same according to another embodiment of the present disclosure.
FIG. 4C is a diagram illustrating a multi-connection switch "c", that is, an example of the multi-connection switch structure in which the number of switches and the number of paths are the same according to still another embodiment of the present disclosure.
FIG. 4D illustrates the inside of a multi-connection switch 700 that is constructed by using a copper bus bar according to still another embodiment of the present disclosure.
FIG. 5 is a diagram illustrating a charging adapter when several charging adapters are connected between two multi-connection switches according to an embodiment of the present disclosure.
FIG. 6A is a diagram illustrating an example in which the request power manipulation units are two in number and are independently constructed in a parking space in which only an electric vehicle can be parked according to an embodiment of the present disclosure.
FIG. 6B is a diagram illustrating an example of a construction in which multi-connection switches that are disposed in adjacent parking surfaces in a parking space in which only an electric vehicle can be parked are bound by one line and managed in a multi-connection switch line unit according to an embodiment of the present disclosure.
FIG. 6C is a diagram illustrating an example of a construction in which adapters or adapter storage boxes that are disposed in adjacent parking surfaces in a parking space in which only an electric vehicle can be parked are bound by one line and managed in an adapter or adapter storage box line unit as an embodiment of the present disclosure.
FIG. 7A is a diagram illustrating an example in which the request power manipulation units are two in number and independently constructed in a parking space in which an electric vehicle, an internal combustion engine vehicle, etc. can be freely parked as another embodiment of the present disclosure.
FIG. 7B is a diagram illustrating an example of a construction in which multi-connection switches that are disposed in adjacent parking surfaces in a parking space in which an electric vehicle, an internal combustion engine vehicle, etc. can be freely parked in relation to FIG. 7A of the present disclosure are bound by one line and managed in a multi-connection switch line unit.
FIG. 7C is a diagram illustrating an example of a construction in which adapters or adapter storage boxes that are disposed in adjacent parking surfaces in a parking space in which an electric vehicle, an internal combustion engine vehicle, etc. can be freely parked in relation to FIG. 7A of the present disclosure may be bound by one line and managed in an adapter or the adapter storage box line unit.
FIG. 8A is a diagram illustrating a flowchart (a) of an embodiment in a method of compensating for a voltage drop according to an embodiment of the present disclosure.
FIG. 8B is a diagram illustrating a flowchart (b) of another embodiment in a method of compensating for a voltage drop according to another embodiment of the present disclosure.
FIG. 8C is a diagram illustrating a flowchart (c) of another embodiment in a method of compensating for a voltage drop according to still another embodiment of the present disclosure.
FIG. 8D is a diagram illustrating a flowchart (d) of another embodiment in a method of compensating for a voltage drop according to still another embodiment of the present disclosure.

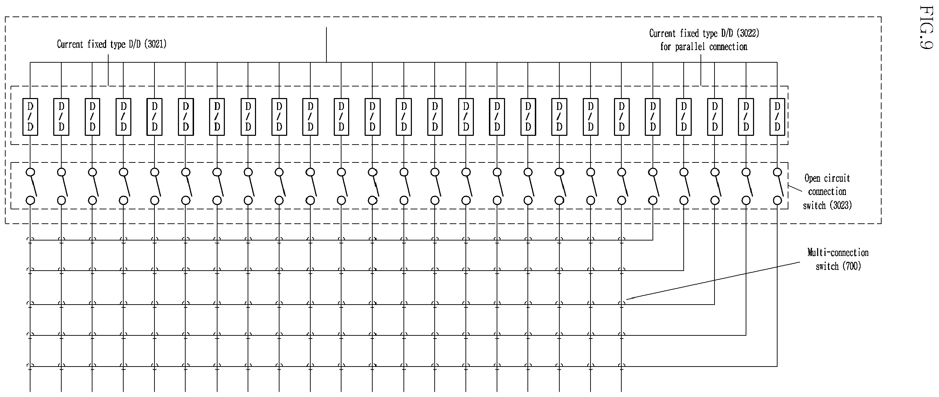

FIG. 9 is a diagram illustrating a construction "b" of a DC/DC converter, that is, a method of determining the number of current fixed type DC/DC converters based on the number of simultaneously chargeable electric vehicles and determining a charging speed without a change based on production power of the current fixed type DC/DC converter, but a method of providing requested power by additionally connecting some current fixed type DC/DC converters in parallel and combining charging speeds of DC/DC converters that are connected to the current fixed type DC/DC converters in parallel by using multi-connection switches, in response to a request from a charging wisher according to an embodiment of the present disclosure.
FIGS. 10A to 10D are diagrams illustrating the number of selectable paths according to a form of a power grid according to an embodiment of the present disclosure.
FIG. 11A is a diagram illustrating an overall block diagram of a system using AC power without any change as another embodiment to which a multi-connection apparatus of the present disclosure may be applied.
FIG. 11B is a diagram illustrating a general block diagram of a system in which new renewable energy in AC power has been coupled according to an embodiment of the present disclosure.
FIG. 12A is a diagram illustrating a detailed system construction diagram (a) illustrating a detailed construction of a system in which the request power manipulation unit is disposed outside the vicinity of a parking lot and the request power manipulation unit and the intra-parking lot power grid are connected by a relay connection power grid according to an embodiment of the present disclosure.
FIG. 12B is a diagram illustrating a detailed system construction diagram (b) illustrating a detailed construction of a system in which new renewable energy is coupled, the request power manipulation unit is disposed outside the vicinity of a parking lot, and the request power manipulation unit and the intra-parking lot power grid are connected by a relay connection power grid according to an embodiment of the present disclosure.
FIG. 13A is a diagram illustrating an example "a" of an operation of a multi-connection switch in which a path has been formed up and down in the multi-connection switch according to an embodiment of the present disclosure.
FIG. 13B is a diagram illustrating an example "b" of an operation of a multi-connection switch in which a path has been formed left and right in the multi-connection switch according to another embodiment of the present disclosure.
FIG. 13C is a diagram illustrating an example "c" of an operation of a multi-connection switch in which a path has been formed left and up in the multi-connection switch according to still another embodiment of the present disclosure.
FIG. 13D is a diagram illustrating an example "d" of an operation of a multi-connection switch in which a path has been formed right and up in the multi-connection switch according to still another embodiment of the present disclosure.
FIG. 13E is a diagram illustrating an example "e" of an operation of a multi-connection switch in which a path has been formed left and down in the multi-connection switch according to still another embodiment of the present disclosure.
FIG. 13F is a diagram illustrating an example "f" of an operation of a multi-connection switch in which a path has been formed right and down in the multi-connection switch according to still another embodiment of the present disclosure.
FIG. 13G is a diagram illustrating an example "g" of an operation of a multi-connection switch in which two paths that are not overlapped up and down, and left and right have been formed in the multi-connection switch according to still another embodiment of the present disclosure.
FIG. 13H is a diagram illustrating an example "h" of an operation of a multi-connection switch in which two paths that are not overlapped left and up, and right and down have been formed in the multi-connection switch according to still another embodiment of the present disclosure.
FIG. 13I is a diagram illustrating an example "i" of an operation of a multi-connection switch in which two paths that are not overlapped right and up, and left and down have been formed in the multi-connection switch according to still another embodiment of the present disclosure.
FIG. 13J is a diagram illustrating an example "j" of an operation of a multi-connection switch in which a path has been formed up and down in a connection switch in which the number of switches is greater than the number of paths according to still another embodiment of the present disclosure.
FIG. 14 is a diagram illustrating an example in which power is supplied from a DC/DC converter group to a charging adapter by combining charging speeds in response to a request from a charging wisher.
FIG. 15 is a diagram illustrating an example of a combination of charging speeds that are combined from the DC/DC converter to the charging adapter in response to a request from a charging wisher according to an embodiment of the present disclosure.

### Mode for Invention

In this document, a "charging wisher" means a person who wishes charging, and a "charging target vehicle" means a vehicle to be charged.

Furthermore, "current fixed type D/D" means a current fixed type DC/DC converter, "current variable type D/D" means a current variable DC/DC converter, and "D/D" means a DC/DC converter.

Furthermore, a "DC power delivery system" is a name that collectively refers to a request power manipulation unit and a connection power grid. A "connection power grid" is a name that collectively refers to a relay connection power grid and an intra-parking lot power grid.

Furthermore, terms including ordinal numbers, such as a "first" and a "second", and terms including letters, such as (a) and (b), may be used to describe various components, but the components are not restricted by the terms. The terms are used to only distinguish one element from the other elements.

Furthermore, in the present disclosure, a "DC/DC converter corresponding to a maximum number of simultaneously chargeable electric vehicles" means that in principle, the number of D/Ds is determined based on the number of simultaneously chargeable electric vehicles. For example, in general, the number of simultaneously chargeable electric vehicles and the number of DC/DCs identically have a ratio of 1 to 1. However, in another embodiment of the present disclosure, the number of D/Ds may be slightly greater or smaller than the number of simultaneously chargeable electric vehicles due to a slight difference in a system.

For example, among embodiments of the present disclosure, as in FIG. 9, the number of D/Ds may be greater than the number of simultaneously chargeable electric vehicles for a parallel connection. If an additional expansion is considered or for the diversity of a charging speed (requested power) that is selected by a charging wisher, the number of D/Ds may be greater than the number of simultaneously chargeable electric vehicles.

Furthermore, as a slightly modified form of a system of the present disclosure, power that is received via one connection power grid may be branched at adapters two or three parking spaces, if necessary, at the rear end of the system, and vehicles may be simultaneously charged. In this case, there is a good possibility that a safety problem, such as a case in which open circuit timing of each of many vehicles is different after charging for each vehicle, may occur. However, the present disclosure includes the possibility that the problem will be solved by an apparatus including a diode, etc. However, in the present disclosure, the number of chargeable electric vehicles in this case is considered to be one, not two or three.

In other words, this means that after power is supplied through one formed connection power grid and charging is performed, the number of chargeable electric vehicles is considered to be 1 in the concept in which the power is disconnected by an open circuit connection switch of a corresponding D/D converter.

Furthermore, from an actual usable aspect, a small number of simultaneously chargeable electric vehicles may be used depending on a construction of a charging speed of a D/D. In a charging system according to the present disclosure, when the amount of electricity used reaches the amount of electricity permitted, the amount of electricity used may not be used because the amount of electricity used cannot exceed the amount of electricity permitted although there is a D/D that has not been used.

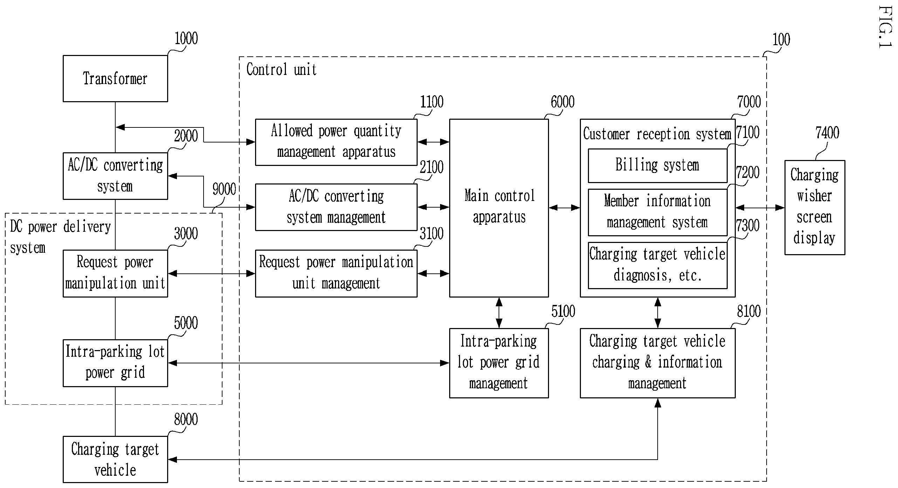

An overall block diagram of a system according to an embodiment of the present disclosure includes a transformer 1000 and an AC/DC converting system 2000, a DC power delivery system 500, a charging target vehicle 9000, a charging wisher screen display 9100, and a control unit 400, as illustrated in FIG. 1.

In an embodiment of the present disclosure, the transformer 1000 is indicated, but the corresponding name may include pieces of equipment that is necessary for a process for power reception, power distribution, and transformation in general, such as power reception and distribution equipment, including power reception for receiving power generated by a power plant and a power distribution for distributing the power as the amount of power that is necessary for a consumer, power transformation equipment for power transformation, a panel board, etc.

The size of an AC voltage that is transformed by the transformer 1000 may be different depending on the size of a DC voltage of power generated by a power plant, which is used by the DC power delivery system 500. The size of an AC voltage that is transformed is determined by considering a transformation, etc.

Furthermore, in an embodiment of the present disclosure, AC power that is generated by a power plant is basically described, but pieces of equipment for converting supplied DC power may be included if the power is supplied to high voltage DC transmission (HVDC) that recently attracts attention.

Furthermore, if proper electricity that is necessary on the outside is present, the electricity may be used without any change. In this case, the transformer may not be included in the system of the present disclosure. In this case, a transformer somewhere on the outside becomes the transformer of the present disclosure.

Power that is supplied from the outside is transformed by the transformer 1000. The power that is transformed as described above is supplied to the AC/DC converting system 2000. The AC/DC converting system 2000 plays a role to primarily convert AC power supplied by the transformer into DC power and supply the DC power.

Power that is input to the transformer via processes, such as a power plant, power transmission, and power distribution, is unstable. If power that is unstable as described above is directly converted and used as a DC voltage, a problem, such as a malfunction or deterioration, may occur because unstable power is supplied.

AC power is primarily converted into DC power through the AC/DC converting system 2000. The converted DC power is stabilized in a request power manipulation unit 3000 through DC/DC conversion, and may be used upon charging of the charging target vehicle 9000.

The DC power delivery system 500 may include the request power manipulation unit 3000 and a connection power grid 600. The connection power grid 600 may include a relay connection power grid 4000 and an intra-parking lot power grid 5000. The relay connection power grid 4000 may be omitted from the connection power grid 600, if necessary.

The request power manipulation unit 3000 controls the selection of a D/D or a combination of D/Ds, the setting of a charging speed (requested power), etc. in order to provide a charging speed (requested power) of a charging wisher, and plays a role to supply a charging speed (requested power) or release the supply of a charging speed (requested power).

In this case, the charging speed of the charging wisher includes a set speed that has been previously agreed or published although the charging speed has not been requested at that time. Furthermore, the system may autonomously apply a proper time and charging speed depending on a forwarding time of a charging wisher, which may be included in the meaning of the charging speed of the charging wisher in that a charging time and a charging speed have been determined based on the will of the charging wisher.

For example, a charging wisher may access an adapter in a parking zone at 6:00 p.m., and may set a departure time to 8:00 a.m. In this case, if a charging rate 90% has only to be performed until the time and a charging rate that have been previously agreed with the charging wisher, for example, the departure time (or 30 minutes prior to the departure time), the system of the present disclosure may adjust a charging speed and a charging time while properly handling various situations according to artificial intelligence or an algorithm. In the present disclosure, even this case may be considered as one of desired charging speed types of the charging wisher.

Therefore, the request power manipulation unit may directly receive a wish list of a charging wisher and may manipulate the wish list. However, it may be considered that a more preferred shape is that a wish list, such as a charging speed of a charging wisher, is interpreted by a main control apparatus and manipulated in response to a control command that is given in accordance with a general situation.

The relay connection power grid 4000 is disposed between a requested power provision electrical wire 3013 that supplies a charging speed (requested power) set in the request power manipulation unit 3000 and the intra-parking lot power grid 5000, and may be used to form a path so that a charging speed (requested power) is supplied up to the intra-parking lot power grid 5000 along a proper path.

The intra-parking lot power grid 5000 is connected to the relay connection power grid 4000, and may play a role to provide a charging speed (requested power) by forming a charging path up to a location where the charging target vehicle 9000 is present. However, intrinsically, the intra-parking lot power grid 5000 may play a role to treat the relay connection power grid 4000 to be similar in a lump or to be arbitrarily different.

The charging target vehicle 9000 means a vehicle to be charged, and is supplied with a charging speed (requested power) requested by a charging wisher via the request power manipulation unit 3000, the relay connection power grid 4000, and the intra-parking lot power grid 5000.

The control unit 400 may include a main control apparatus 6000, an allowed power quantity management apparatus 1100, AC/DC converting system management 2100, request power manipulation unit management 3100, relay connection power grid management 4100, intra-parking lot power grid management 5100, charging target vehicle charging and information management 8000, and a customer reception system 7000.

The main control apparatus 6000 may play a role to transmit notification to or transmit and receive information to and from a terminal of a charging wisher through the management and control of overall systems for charging, internal or external communication, and control of the customer reception system 7000.

Various methods for wired communication or wireless communication, such as PLC, a CAN, a LAN, a LIN, Bluetooth, Zigbee, and Beacon, may be used as communication methods that are used to perform internal or external communication in the main control apparatus 6000.

The allowed power quantity management apparatus 1100 plays a role to consistently monitor and control power that is used in the charging system according to the present disclosure so that the power does not exceed total power that is acceptable for the transformer 1000. To this end, in general, the allowed power quantity management apparatus 1100 may include equipment, software, or a panel board for monitoring and controlling power.

In this case, the acceptable total power may mean, in principle, the amount of power that is permitted according to a contract with an electricity supply source (KEPCO, etc. in Korea) regardless of whether a transformer is present or not.

The AC/DC converting system management 2100 may play a role to consistently monitor and control power that is supplied by the transformer 1000 so that the supplied power does not exceed power that is determined when the supplied power is primarily converted into DC power. In general, the AC/DC converting system management 2100 may include equipment, software, or a panel board for monitoring and controlling power.

If not one AC/DC converting system, but several AC/DC converting systems are constructed, the AC/DC converting system management 2100 may monitor and control each of AC/DC converting systems 2010, 2020, 2030, 2040, and 2050.

The request power manipulation unit management 3100 may play a role to perform control, such as selecting or combining D/Ds in response to a request from a charging wisher or determining and supplying or blocking a charging speed (requested power), and to identify problems, such as a breakdown and the leakage current.

The relay connection power grid management 4100 may play a role to form a path for supplying a charging speed (requested power) set in the request power manipulation unit 3000 up to the intra-parking lot power grid 5000 in which the charging target vehicle 9000 has been disposed and to release the forming of the path after charging is completed.

The intra-parking lot power grid management 5100 may play a role to form a path for supply a charging speed (requested power) that is supplied by the relay connection power grid 4000 up to a location of the charging target vehicle 9000 and to release the forming of the path after charging is completed.

The charging target vehicle charging and information management 8000 may play a role to determine information, such as battery information, the amount of remaining battery power, and vehicle information that are received from the charging target vehicle 9000, and whether the charging target vehicle 9000 that is connected to a corresponding charging system is a vehicle which may be charged in the corresponding charging system.

The customer reception system 7000 may include a billing system 7100, a member information management system 7200, and charging target vehicle diagnosis, etc. 7300. In an embodiment according to the present disclosure, the customer reception system 7000 is described by being divided into the three types, but this is an example. When a system is constructed, a system may be added, if necessary.

The billing system 7100 plays a role to calculate and pay a bill according to bill information for each time zone/each season and power used for charging. The member information management system 7200 may play a role to store payment information, vehicle information, schedule information, etc. of a charging wisher.

The charging target vehicle diagnosis, etc. 7300 may play a role to store information that is received from the charging target vehicle charging and information management 8000 and to deliver the information to a charging wisher depending on information.

The charging wisher screen display 9100 means that information that is transmitted by the customer reception system 7000 is displayed on a terminal, such as a smartphone or computer of a charging wisher.

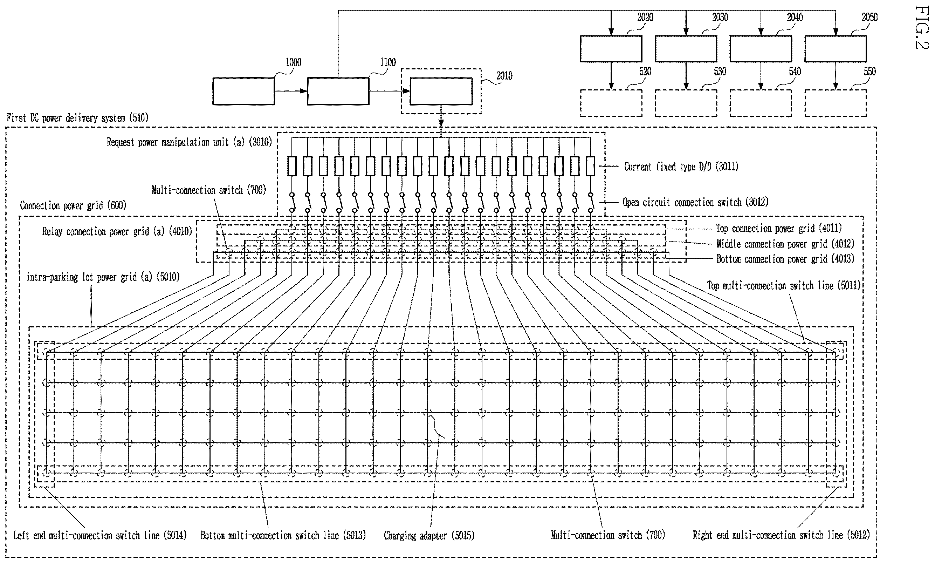

FIG. 2 represents, as an example, a general structure from the transformer 1000 to a charging adapter 5015 at a place where the charging target vehicle 9000 has been disposed according to an embodiment of the present disclosure, and may be constructed to include the transformer 1000, the allowed power quantity management apparatus 1100, the AC/DC converting system 2000, and the DC power delivery system 500.

The AC/DC converting system 2000 of FIG. 2 may be a plural number. For example, the AC/DC converting system 2000 may be constructed in a plural number like first to fifth AC/DC converting systems 2010, 2020, 2030, 2040, and 2050. The DC power delivery system 500 may be constructed by connecting first to fifth DC power delivery systems 510, 520, 530, 540, and 550 to the first to fifth AC/DC converting systems 2010, 2020, 2030, 2040, and 2050, respectively.

In the embodiment, five AC/DC converting systems 2000 and five DC power delivery systems 500 have been constructed, but this is merely an example according to an embodiment of the present disclosure, and the number of AC/DC converting systems may be greater or smaller than 5.

FIG. 2 has been described by taking, as an example, the first AC/DC converting system 2010 and the first DC power delivery system 510, among the first to fifth AC/DC converting systems 2010, 2020, 2030, 2040, and 2050 and the first to fifth DC power delivery systems 510, 520, 530, 540, and 550.

DC power that is generated by the first to fifth AC/DC converting systems 2010, 2020, 2030, 2040, and 2050 and DC power of the first to fifth DC power delivery systems 510, 520, 530, 540, and 550 may use DC power having the same size, and may use DC power having different sizes, if necessary.

In particular, in this case, a voltage of a power used may be variously generated and used, if necessary, by those skilled in the art if the sizes of standard voltages of electric vehicles that are sold on the market are variously different. For example, if charging standard voltages of electric vehicles are 800 V and 400 V, all the charging standard voltages may be accommodated by considering the ratio of the number of vehicles of the two vehicles.

Furthermore, detailed structures of the request power manipulation units 3000, relay connection power grids 4000, and intra-parking lot power grids 5000 of the first to fifth DC power delivery systems 510, 520, 530, 540, and 550 may be the same or may be differently constructed, if necessary.

FIG. 2 is an embodiment according to the present disclosure, including a construction in which the request power manipulation unit 3000 is connected to a current fixed type D/D 3021, the relay connection power grid 4000 has a pyramid form (a structure in which the number of power grids is increased), and an electrical wire 900 to which the intra-parking lot power grid 5000 and the relay connection power grid 4000 are connected is connected to a top multi-connection switch line 5011.

In the embodiment, a charging speed (requested power) that is determined by a current fixed type D/D 3011 of a request power manipulation unit (a) 3010 may be selected as a charging speed (requested power) that is requested by a charging wisher. The corresponding charging speed (requested power) may be supplied to the charging adapter 5015 connected to the charging target vehicle 9000 in the state in which there is a good possibility that another path will be formed whenever a path having the number of many cases is formed between a relay connection power grid (a) 4010 and a first intra-parking lot power grid 5010 in principle.

All of the current fixed type D/Ds 3011 of the request power manipulation unit (a) 3010 may supply charging speeds (requested power) having the same size, but may supply charging speeds having different sizes. The charging speed (requested power) of each current fixed type D/D 3011 may be variously determined by considering a situation in a corresponding parking lot upon installation.

In the embodiment, when the current fixed type D/D 3011 of the request power manipulation unit (a) 3010 is selected based on a determination of the main control apparatus in response to the selection of a charging speed (requested power) by a charging wisher, a path is formed between the relay connection power grid (a) 4010 and the first intra-parking lot power grid 5010. When a corresponding task is completed, the charging speed (requested power) may be supplied by making ON an open circuit connection switch 3012 of the request power manipulation unit (a) 3010.

Furthermore, there is an advantage in that a charging speed (requested power) can be provided from slow charging to quick charging using DC power by variously constructs D/Ds in response to the selection of a charging wisher.

If a path is formed when electricity flows, various electrical problems, such as a counter electromotive force, may occur. However, if a charging speed (requested power) is supplied by making ON the open circuit connection switch 3012 after a path is formed as in the embodiment, there is an advantage in that such a problem can be prevented.

Furthermore, although not separately illustrated in the embodiment, as in the present disclosure, a device, such as a DC circuit breaker for blocking a fault current when a breakdown occurs while DC power is used, may be added. Devices capable of preventing an accident which may occur while DC power is used, such as a reverse current relay, an earthly world relay, and a remaining current device, may be additionally used.

Furthermore, in the embodiment, the D/Ds of the request power manipulation unit have been represented, but the D/Ds of the request power manipulation unit may include various design methods or constructions for DC/DC conversion in addition to DC/AC conversion - AC/DC conversion depending on an advantage in design or circumstances.

In the present disclosure, not electricity for charging an electric vehicle, but AC for common households may be used as electricity that makes move a multi-connection switch 700 that is used in the connection power grid 600 in order to set a path.

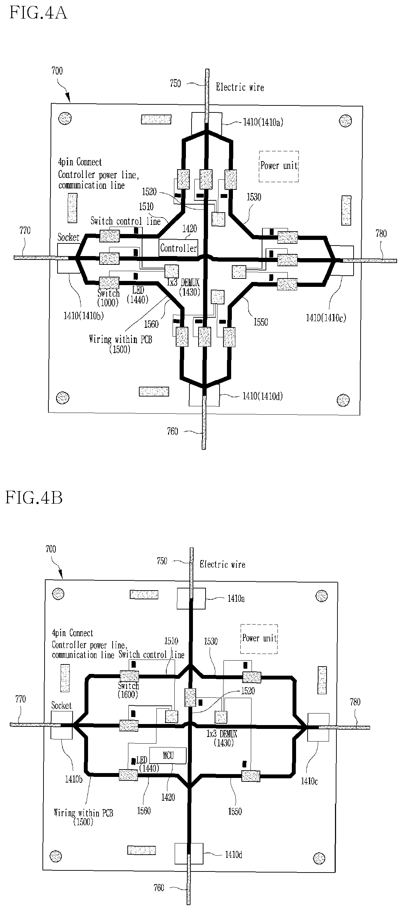

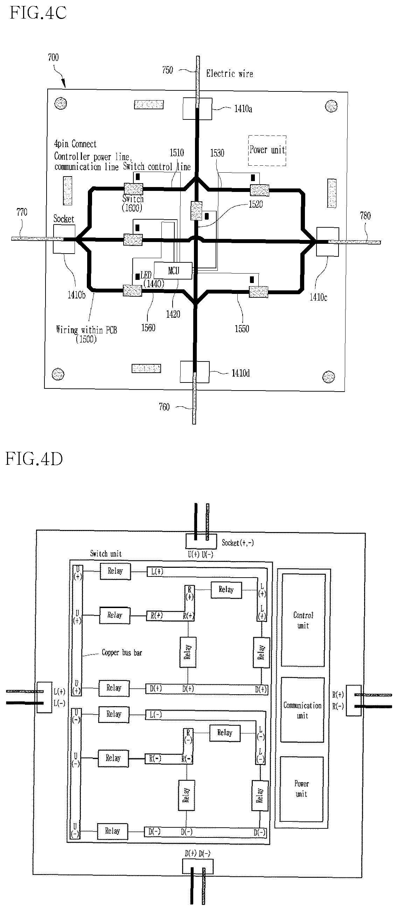

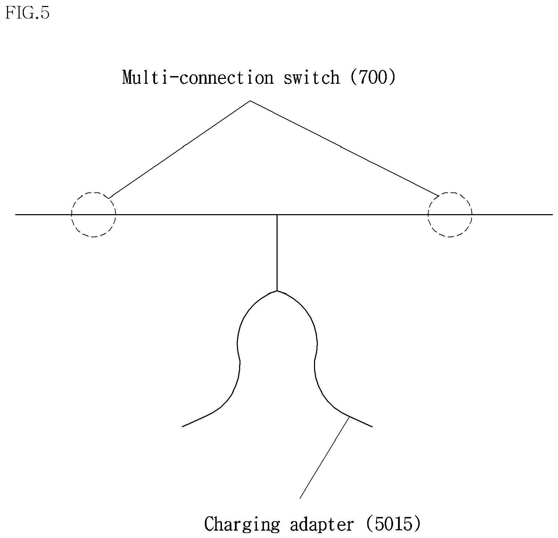

When the multi-connection switch 700 used in the present disclosure is constructed like FIGS. 4A, 4B, 4C, and 5D as one embodiment, electrical wires connected to the multi-connection switch 700 may have a total of six paths. Paths may be formed at the top and the bottom, the top and the left end, the top and the right end, the bottom and the left end, and the bottom and the right end. One path is basically formed, but two paths may be simultaneously formed if the two paths are not overlapped according to circumstances.

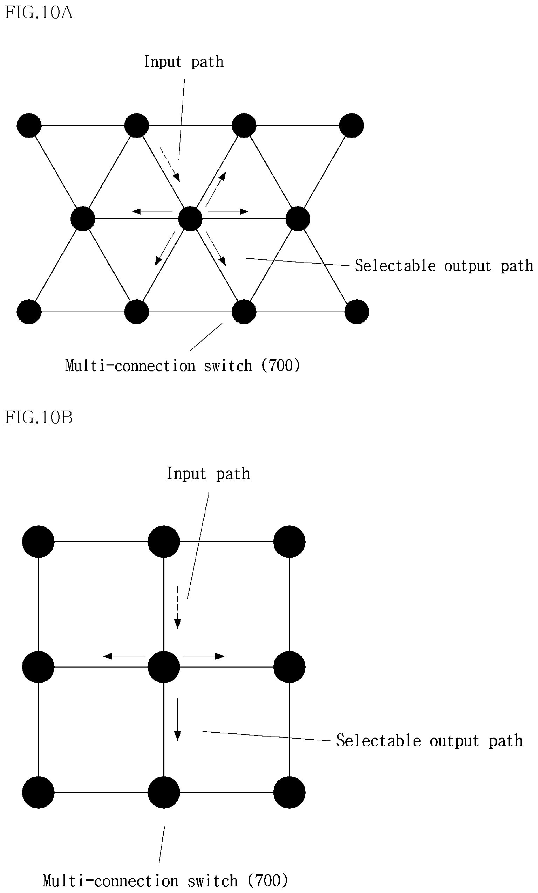

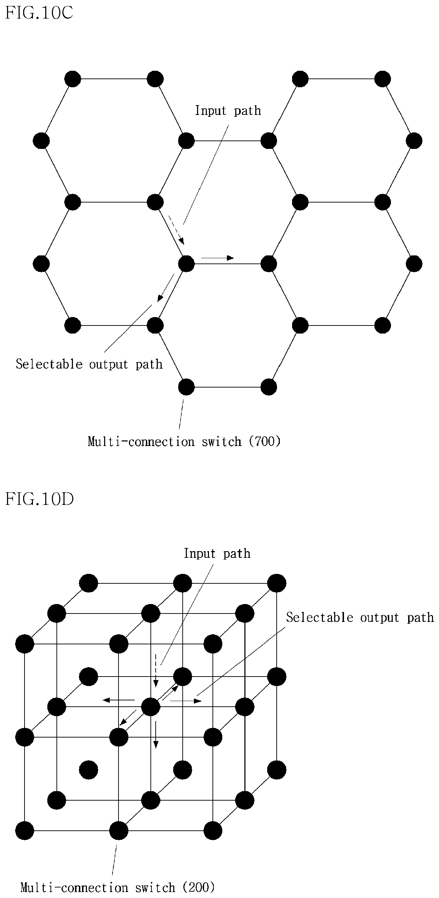

Furthermore, the connection power grids may be connected as a triangle, a hexagon, etc. in which the connection power grids are connected in all directions as in FIGS. 10A to 10D. Alternatively, the connection power grids may also be connected as a three-dimensional connection structure. For example, the connection power grids may have a regular tetrahedron or a regular hexahedron. A shape of the connection power grids may be slightly crushed and used, if necessary. Furthermore, these shapes may be mixed and used.

An important point is whether the number of cases of connection paths of the multi-connection switch 700 can be sufficiently secured so that a new path can be formed without a crosstalk with the paths of the charging target vehicles 9000 whose paths have already been formed and that are being charged, which are various and may be said to be randomly connected in principle, among chargeable adapters in many parking lots the number of which is much large in the request power manipulation unit 3000 having a small number of power supply lines.

Therefore, the multi-connection switch 700 is installed in all or most of edges that are formed by the connection power grid. However, if the number of cases of connection paths can be sufficiently secured, the multi-connection switch 700 may not be installed in all the edges, and the number of connectable cases per switch may be reduced.

How many charging adapters will be installed within a parking space is an important thing. Most preferably, the adapter may be installed in all of parking spaces. The reason for this is that in such a case, there is an advantage in that car owners can park regardless of an internal combustion engine vehicle or an electric vehicle. Furthermore, the reason for this is that if the proportion of electric vehicles is subsequently continuously increased, handling is possible by only supplementing a transformer, an AC/DC converter, and a D/D converter at the top.

Accordingly, for example, in the present disclosure, if a maximum number of simultaneously chargeable electric vehicles are 60, 400 or 500 adapters may be installed in a parking space. However, the numbers may be variously applied as contents that need to be properly determined by those skilled in the art by considering a situation, depending on the proportion of electric vehicles among all vehicles, use shapes of the electric vehicles, etc. Furthermore, a considerable number of adapters in a parking space may be omitted according to circumstances. However, a core of the present disclosure may be that the meaning that the connection power grid is installed is effective in the system partially or entirely because at least the number of adapters is much greater than a maximum number of simultaneously chargeable electric vehicles.

As still another embodiment, the request power manipulation unit 3000 may be directly connected to the intra-parking lot power grid 5000 without the relay connection power grid 4000. For example, if the multi-connection switch 700 within a parking lot has been installed, but there are many places where the charging adapter 5015 is not present if necessary or the number of cases of paths is sufficient, the request power manipulation unit 3000 may be directly connected to the intra-parking lot power grid 5000 through the portion. The reason for this is that even in this case, the number of cases of connection paths for the multi-connection switch 700 can be sufficiently secured.

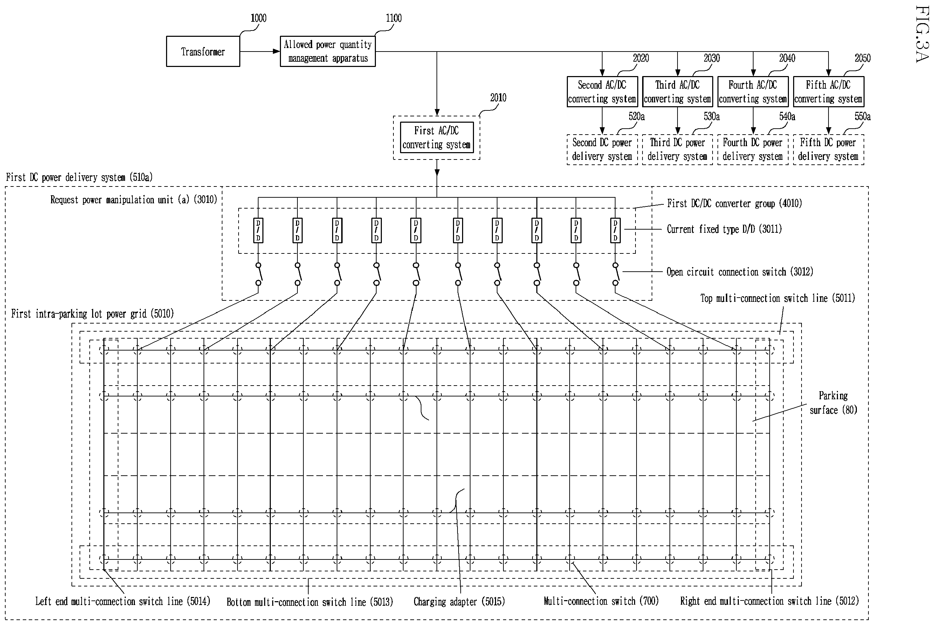

FIG. 3A represents as an example, a general structure from the transformer 1000 to the charging adapter 5015 at the place where the charging target vehicle 9000 is disposed according to an embodiment of the present disclosure.

Referring to FIG. 3A, the charging system for an electric vehicle according to an embodiment of the present disclosure may be constructed to include the transformer 1000, the allowed power quantity management apparatus 1100, the AC/DC converting system 2000, and a DC power delivery system 500a.

If a transformer that has been previously installed can handle power used for charging, power may be supplied by using the corresponding transformer without separate installation instead of the transformer 1000 in FIG. 3A. If a transformer that has been previously installed cannot handle power used for charging, power may be supplied through the installation of an additional transformer 1000.

In FIG. 3A, the AC/DC converting system 2000 may be one in number or may be constructed in a plural number. For example, the AC/DC converting system 2000 may be constructed in a plural number like first to fifth AC/DC converting systems 2010, 2020, 2030, 2040, and 2050 and may be constructed as one AC/DC converting system. The DC power delivery system 500 may be constructed by connecting first to fifth DC power delivery systems 510, 520, 530, 540, and 550 to the first to fifth AC/DC converting systems 2010, 2020, 2030, 2040, and 2050, respectively.

Furthermore, the request power manipulation unit 3000 may be separately provided in each of the first to fifth AC/DC converting systems 2010, 2020, 2030, 2040, and 2050. That is, the first to fifth AC/DC converting systems 2010, 2020, 2030, 2040, and 2050 may be connected to first to fifth request power manipulation units 3010, 3020, 3030, 3040, and 3050, respectively.

In the embodiment, five AC/DC converting systems 2000, five DC power delivery systems 500, and five request power manipulation units 3000 have been constructed, but they are merely examples according to an embodiment of the present disclosure and the numbers of AC/DC converting systems may be greater or smaller than 5.

Furthermore, in the embodiment of FIG. 3A, the DC power delivery system 500a has been connected to the AC/DC converting system 2000 in a one-to-one way. This is merely an example according to an embodiment of the present disclosure, and the DC power delivery system 500a may be connected to the AC/DC converting system 2000 in a one-to-many way.

In FIG. 3A, the first AC/DC converting system 2010 and the first DC power delivery system 510a, among the first to fifth AC/DC converting systems 2010, 2020, 2030, 2040, and 2050 and the first to fifth DC power delivery systems 510a, 520a, 530a, 540a, and 550a, have been described as an example.

Power that may be supplied by the first to fifth AC/DC converting systems 2010, 2020, 2030, 2040, and 2050 may be all the same. The amounts of power which may be supplied by the systems may be different from each other. Furthermore, the sizes of DC power of the request power manipulation units 3000 included in the first to fifth DC power delivery systems 510a, 520a, 530a, 540a, and 550a, respectively, may be all the same. The request power manipulation units 3000 may be constructed by using DC power having different sizes, if necessary.

In particular, in this case, the sizes of charging voltages in power, which are used in electric vehicles that are sold on the market, may be various. Accordingly, the sizes of the charging voltages may be variously constructed when a system is constructed, if necessary. For example, if the sizes of charging voltages for electric vehicles are 800 V and 400 V, a system may be constructed by considering the ratio of the number of electric vehicles in which the two voltages are used.

Furthermore, detailed structures of the request power manipulation unit 3000 of each of the first to fifth DC power delivery systems 510a, 520a, 530a, 540a, and 550a and the intra-parking lot power grid 5000 may be the same as detailed structures of the first request power manipulation unit 3010 and the first intra-parking lot power grid 5010, but may be differently constructed, if necessary.

FIG. 3A exemplifies a charging system for an electric vehicle in which the AC/DC converting system and the request power manipulation unit according to an embodiment of the present disclosure have been separated.

FIG. 3A is a diagram illustrating a case in which several AC/DC converting systems 2000 are constructed and one request power manipulation unit 3000 has been constructed in the AC/DC converting system 2000.

Furthermore, FIG. 3A is a diagram illustrating a case in which the request power manipulation unit 3000 is separately present in each of the first to fifth AC/DC converting systems 2010, 2020, 2030, 2040, and 2050 and the first to fifth AC/DC converting systems 2010, 2020, 2030, 2040, and 2050 and the request power manipulation units 3000 are constructed outside the vicinity of a parking lot.

In this case, the outside means another separate space not an area of a corresponding parking lot. The outside may be an installation space where the AC/DC converting system 2000 and the request power manipulation unit 3000 may be constructed as a separate place in the vicinity of the parking lot.

Furthermore, in this case, the separate space may include an area other than the area of the parking lot in which the AC/DC converting system 2000 and the request power manipulation unit 3000 are responsible for charging in the entire area of the parking lot, and may be a space separated from the parking lot. The charging adapter 5015 needs to be connected to the separate space via the D/D open circuit connection switch 3012 and the multi-connection switch 700.

Furthermore, if the AC/DC converting system 2000 and the request power manipulation unit 3000 are constructed outside the vicinity of a parking lot, AC power is supplied up to the vicinity of the parking lot.

Furthermore, the embodiment is an embodiment according to the present disclosure if the multi-connection switch 700 is constructed only on a parking surface 80 and one charging adapter 5015 can charge one electric vehicle.

In the embodiment, a charging speed (requested power) that is determined by the current fixed type D/D 3011 of the first request power manipulation unit 3010 may be selected as a charging speed (requested power) that is requested by a charging wisher. The corresponding charging speed (requested power) may be variously supplied from the intra-parking lot power grid 5010 to the charging adapter 5015 and the charging target vehicle 9000 by the forming of a path depending on a current location of the charging target vehicle 9000. The path for charging may be formed to use at least the multi-connection switch 700 through the shortest distance by avoiding an existing path.

As still another embodiment, multiple AC/DC converters may be directly connected to the request power manipulation unit including the open circuit connection switch that supplies or blocks a DC current to be charged by finely fabricating the multiple AC/DC converters, for example, AC/DC converters that are used without adding a DC/DC converter to a charger that is necessary in the present disclosure.

The most important point in a process of forming a path is to form a path capable of minimizing a voltage drop according to the length of an electrical wire of a formed path and the number of multi-connection switches. A control program may calculate a voltage drop according to the lengths of electrical wires of paths that are formed through simulations when the paths are formed and the number of multi-connection switches, and may select a path having the smallest voltage drop among the paths.

Furthermore, in another case, if only the forming of a path that minimizes the voltage drop is taken care of, the parking surface 80 in which a charging path has not been formed may occur. In order to supplement such a problem, the control program may previously simulate the forming of a path up to each parking surface, and may select a path having the smallest voltage drop so that an additional path can be easily formed.

Accordingly, as an additional option, a recommended parking surface may be displayed by installing an LED light, etc. at the top of the parking surface 80 so that the LED light blinks.

Furthermore, in order to minimize a case in which a charging path has not been formed, it may be important to minimize the forming of a path in which two or more multi-connection switches 700 installed on the parking surface 80 are continuously used. If a path is formed by continuously using the multi-connection switches 700 installed on the parking surface 80, it may be difficult to form an additional path for charging with the corresponding charging adapter 5015 of the multi-connection switches 700 that are used for only a connection. Accordingly, it may be difficult to charge an electric vehicle although the electric vehicle enters the corresponding parking surface 80. Therefore, it is preferred that a charging path is formed by well using the multi-connection switch 700 that has been installed in a passage, etc. by avoiding continuously using the multi-connection switches 700 installed on the parking surface 80.

The three methods of forming a charging path may be independently used. The first and second methods, the first and third methods, and two or more of the three methods may be used depending on the number of multi-connection switches 700 that are installed in a parking lot.

The first request power manipulation unit 3010 includes only a first DC/DC converter group 41 and the open circuit connection switch 3012. The first DC/DC converter group 41 includes only the current fixed type D/D 3011. All of the current fixed type D/Ds 3011 may supply charging speeds (requested power) having the same size, but may supply charging speeds having different sizes. A charging speed (requested power) of each current fixed type D/D 3011 may be variously determined by considering a situation in a corresponding parking lot upon installation.

In the embodiment, the current fixed type D/D 3011 of the first request power manipulation unit 3010 is selected based on a determination of the main control apparatus 6000 in response to the selection of a charging speed (requested power) by a charging wisher. A path for the first intra-parking lot power grid 5010 is first formed. When a corresponding task is completed, the charging speed (requested power) may be supplied by making ON the open circuit connection switch 3012 of the first request power manipulation unit 3010.

There is an advantage in that a charging speed (requested power) can be provided from slow charging to quick charging using DC power in response to the selection of a charging wisher by variously constructing the current fixed type D/D 3011 of the first DC/DC converter group 41. There is an advantage in that a charging system that has been previously constructed can be expanded by additionally installing the AC/DC converting system 2000 and the request power manipulation unit 3000 when the number of electric vehicles is increased.

Furthermore, the embodiment has been described by using only the current fixed type DC/DC as an example, but this is merely a construction according to an embodiment of the present disclosure. As in FIG. 9, a second DC/DC converter group 42 including a current fixed type D/D 3022 for a parallel connection to a current fixed type D/D 3021, a third DC/DC converter group 43 including a current variable type D/D 3031, or a fourth DC/DC converter group 44 in which a current fixed type D/D 3042 and a current variable type D/D 3041 are mixed may be constructed.

If a path is formed when electricity flows, various electrical problems, such as a counter electromotive force, may occur. As in the embodiment, if a charging speed (requested power) is supplied by making ON the open circuit connection switch 3012 after a path is formed, there is an advantage in that such a problem can be prevented.

Furthermore, although not illustrated in the embodiment, as in the present disclosure, a device, such as a DC circuit breaker for blocking a fault current when a breakdown occurs, may be added when DC power is used. Devices capable of preventing an accident which may occur when DC power is used, such as a reverse current relay, an earthly world relay, and a remaining current device, may be additionally constructed.

In order to establish a path, common AC or DC power different from power for charging an electric vehicle may be used as power for an operation of the multi-connection switch 700 that is used in the first intra-parking lot power grid 5010.

The structure of the multi-connection switch 700 that is used in the present disclosure is one embodiment. An example of a case in which the multi-connection switch 700 is connected up and down and left and right as in FIG. 4C, that is, four electrical wires are connected to the multi-connection switch 700, has been described. However, as in FIGS. 10A to 10D, electrical wires greater or smaller than the four electrical wires may be connected to the multi-connection switch 700 depending on a form of a power grid.

Furthermore, shapes of the intra-parking lot power grid 5010 are a triangle, a quadrangle, a hexagon, and a hexahedron as in FIGS. 10A to 10D, but are merely examples according to an embodiment of the present disclosure. The shapes may be more variously constructed like a polygon and a regular tetrahedron, if necessary. The shapes may be mixed and used.

**An** important thing in a charging system according to the present disclosure is that the charging target vehicle 9000 can be charged by variously forming paths in response to a request from a charging wisher by using the charging adapters 5015 that are installed on the parking surface 80 and that are much greater in number than the number of power supply devices in the request power manipulation unit 3000 having the power supply devices smaller than the number of parking surfaces 80, a new path can be formed without a crosstalk with a preset path, and charging can be performed at any place within a parking lot.

Furthermore, the number of multi-connection switches 700 needs to be sufficiently secured so that a new path can be formed by avoiding a crosstalk with the existing path. The multi-connection switch 700 is basically installed in the parking surface 80. If the number of multi-connection switches 700 is insufficient in forming a new path, the multi-connection switch 700 may be additionally installed at a location, such as a passage, other than the parking surface 80.

It is most preferred that the charging adapter 5015 is installed in each of the parking surfaces 80 one by one. In this case, there is an advantage in that in order to charge an electric vehicle, the electric vehicle can be parked at any place without moving the existing internal combustion engine vehicle. Furthermore, there is an advantage in that if the proportion of electric vehicles is subsequently increased, charging can be performed through only the additional installation of the transformer 1000, the AC/DC converting system 2000, and the request power manipulation unit 3000.

For example, if a maximum number of simultaneously chargeable electric vehicles according to the present disclosure are 60, the number of charging adapters 5015 installed in the parking surface 80 may be 400 or 500. However, the numbers may be different depending on the importance, a use form, etc. of electric vehicles compared to all of the parking surfaces 80. The number of charging adapters 5015 may be omitted or increased according to circumstances. A core of the present disclosure is that charging can be performed in all of the parking surfaces 80 or at any place of the parking surface 80 of a specific area according to circumstances because more charging adapters 5015 than a maximum number of simultaneously chargeable electric vehicles are installed.

Furthermore, for example, when a charging wisher connects the charging adapter 5015 to the charging target vehicle 9000 and sets a charging end time, electricity may be controlled to not flow into the charging target vehicle 9000 by releasing the switch of the multi-connection switch 700 to which the charging adapter 5015 is connected, until the start of charging. A charging system according to the present disclosure may control a charging speed, the open circuit connection switch 3012, etc. so that the charging is completed based on the charging end time after the charging is started.

After the charging end time is reached or the charging is completed, although the charging adapter 5015 continues to be connected to the multi-connection switch 700 without being removed, electricity may be set to not flow until a charging wisher releases the connection of the charging adapter 5015 by disconnecting the multi-connection switch 700 to which the charging adapter 5015 has been connected.

Furthermore, a charging rate may be set depending on an operating system and the setting of a charging wisher. In this case, the completion of charging may mean that charging has been completed if the charging up to 80% by quick charging, for example, has been set.

However, in the present disclosure, the completion of charging may mean that charging has been completed when DC quick charging is changed into AC slow charging and charging reaches up to 90% or more, after charging reaches up to 80% by the DC quick charging.

The rapid and AC slow methods are specifically described. For example, when charging reaches up to 80% through quick charging, in a process of releasing a previously formed charging path, the switch of the charging adapter 5015 is first disconnected, the switch of the charger is disconnected, and the multi-connection switch 700 is then disconnected. After DC charging is sufficiently terminated, separate AC power may be supplied to the charging target vehicle 9000 by controlling the switch of the charging adapter 5015 or the adapter storage box.

Furthermore, in the example, the charging adapter 5015 may be disposed in a ceiling or on the surface of a wall of a parking lot, inside/outside the floor of the parking lot, or within a separate housing that is constructed. The charging adapter 5015 may include a module capable of wireless charging using a method, such as magnetic induction, magnetic resonance, or electromagnetic waves, for example, in addition to a wired adapter that is directly connected to the charging target vehicle 9000.

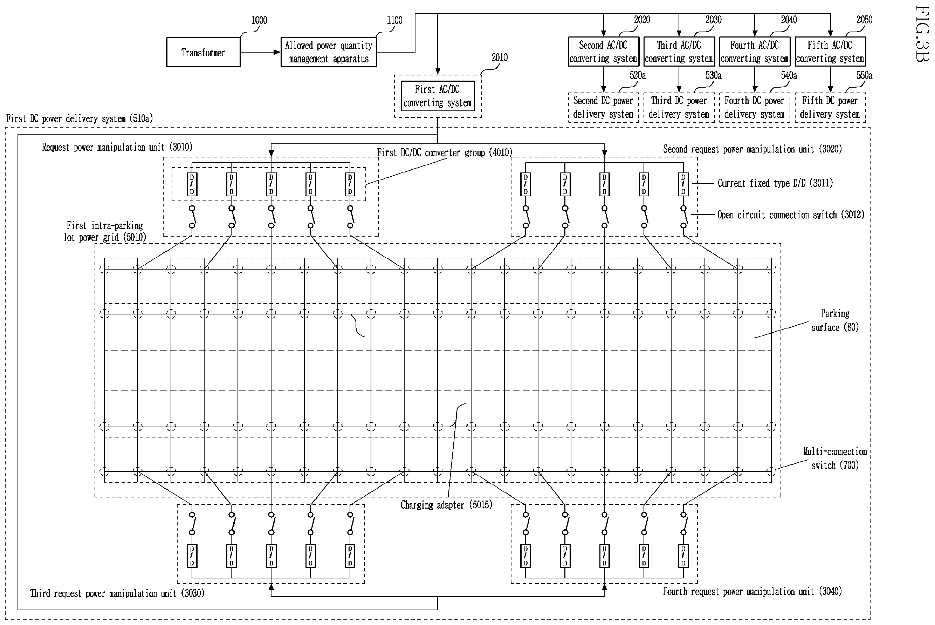

FIG. 3B represents, as an example, a general structure from the transformer 1000 to the charging adapter 5015 at the place where the charging target vehicle 9000 is disposed according to an embodiment of the present disclosure. A charging system for an electric vehicle may be constructed to include the transformer 1000, the allowed power quantity management apparatus 1100, the AC/DC converting system 2000, and the DC power delivery system 500a.

FIG. 3B exemplifies a case in which power grids are interconnected to deliver power.

If a previously installed transformer can handle power used for charging, the corresponding transformer may be used to supply power without separate installation instead of the transformer 1000 in FIG. 3B. If a previously installed transformer cannot handle power used for charging, power may be supplied by installing an additional transformer 1000.

In FIG. 3B, one AC/DC converting system 2000 may be constructed, and the AC/DC converting system 2000 may be constructed in a plural number. For example, the AC/DC converting system 2000 may be constructed in a plural number like the first to fifth AC/DC converting systems 2010, 2020, 2030, 2040, and 2050, and one AC/DC converting system may be constructed.

In the embodiment, five AC/DC converting systems 2000 have been constructed as an example, but this is merely an example according to an embodiment of the present disclosure, and the number of AC/DC converting systems 2000 may be greater or smaller than 5.

Furthermore, in the embodiment of FIG. 3B, the DC power delivery system 500a is connected to the AC/DC converting system 2000 in a one-to-one way, but this is merely an example according to an embodiment of the present disclosure, and the DC power delivery system 500a may also be connected to the AC/DC converting system 2000 in a one-to-many way.

In FIG. 3B, the first AC/DC converting system 2010 and the first DC power delivery system 510a, among the first to fifth AC/DC converting systems 2010, 2020, 2030, 2040, and 2050 and the first to fifth DC power delivery systems 510a, 520a, 530a, 540a, and 550a, have been described as an example.

Power that may be supplied by the first to fifth AC/DC converting systems 2010, 2020, 2030, 2040, and 2050 may be all the same. The amounts of power which may be supplied by the systems may be different from each other. Furthermore, the sizes of DC power of the request power manipulation units 3000 that are included in the first to fifth DC power delivery systems 510a, 520a, 530a, 540a, and 550a, respectively, may be all the same, and the request power manipulation units 3000 may be constructed by using DC power having different sizes, if necessary.

In particular, in this case, the sizes of charging voltages in power, which are used electric vehicles that are sold on the market, may be various. Accordingly, the sizes of the charging voltages may be variously constructed when a system is constructed, if necessary. For example, if the sizes of charging voltages for electric vehicles are 800 V and 400 V, a system may be constructed by considering the ratio of the number of electric vehicles in which the two voltages are used.

Furthermore, detailed structures of the request power manipulation unit 3000 of each of the first to fifth DC power delivery systems 510a, 520a, 530a, 540a, and 550a and the intra-parking lot power grid 5000 may be the same as detailed structures of the first request power manipulation unit 3010 and the first intra-parking lot power grid 5010, but may be differently constructed, if necessary.

A charging system for an electric vehicle according to an embodiment of the present disclosure includes the request power manipulation unit 3000 in a plural number. The plurality of request power manipulation units 3000 may mutually deliver power.

FIG. 3B is a diagram illustrating a case in which several AC/DC converting systems 2000 are constructed, several request power manipulation units 3000 are constructed in the AC/DC converting system 2000, and the first to fourth request power manipulation units 3010, 3020, 3030, and 3040 can mutually deliver power.

Furthermore, FIG. 3B is a diagram illustrating a case in which the request power manipulation unit 3000 is separately present in each of the first to fifth AC/DC converting systems 2010, 2020, 2030, 2040, and 2050 and the first to fifth AC/DC converting systems 2010, 2020, 2030, 2040, and 2050 and the request power manipulation units 3000 are constructed outside the vicinity of a parking lot.

The first to fourth request power manipulation units 3010, 3020, 3030, and 3040 include the first DC/DC converter group 41 and the open circuit connection switch 3012. The first DC/DC converter group 41 includes only the current fixed type D/D 3011. All of the current fixed type D/Ds 3011 may supply charging speed (requested power) having the same size, but may supply charging speeds having different sizes. The charging speed (requested power) of each current fixed type D/D 3011 may be variously determined by considering a situation in a corresponding parking lot upon installation.

Furthermore, in FIG. 3B, an example in which the DC/DC converter group 40 of the first to fourth request power manipulation units 3010, 3020, 3030, and 3040 has been constructed as the first DC/DC converter group 41 including only the current fixed type D/D 3011 has been taken as an example, but this is a construction according to an embodiment of the present disclosure. The DC/DC converter groups 40 of the request power manipulation units 3000 may be all the same or different from each other. This may be variously determined by considering a situation in a corresponding parking lot upon installation.

There are advantages in that a charging speed (requested power) can be provided in response to the selection of a charging wisher from slow charging to quick charging using DC power by variously constructing the current fixed type D/D 3011 of the first DC/DC converter group 41 and a charging system that has been previously constructed can be expanded by additionally installing the AC/DC converting system 2000 and the request power manipulation unit 3000 when the number of electric vehicles is increased.

Furthermore, the embodiment is an embodiment according to the present disclosure illustrating a case in which the multi-connection switch 700 is constructed on the parking surface 80 and one charging adapter 5015 can charge one electric vehicle.

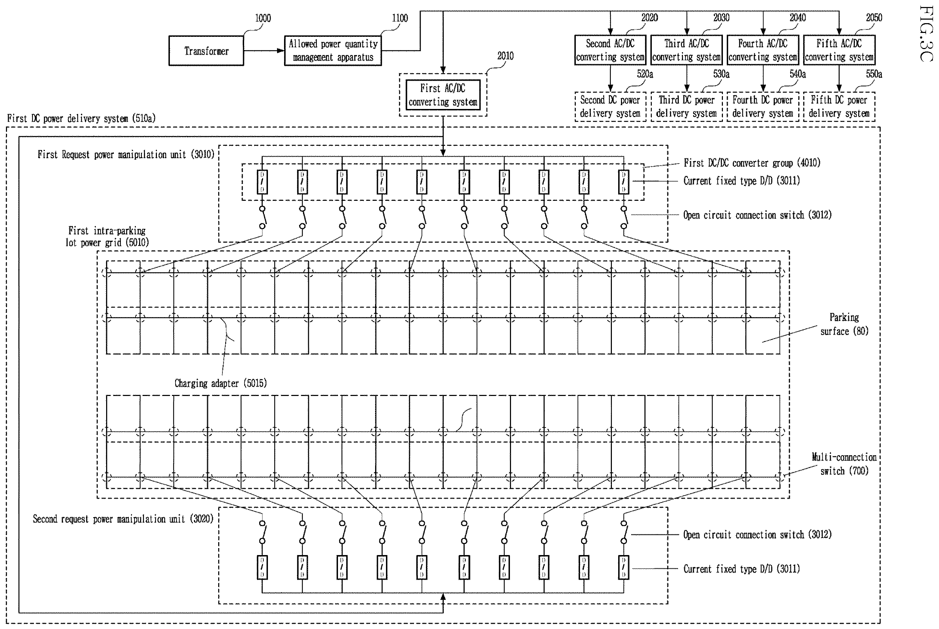

FIG. 3C represents, as an example, a general structure from the transformer 1000 to the charging adapter 5015 at the place where the charging target vehicle 9000 is disposed according to an embodiment of the present disclosure. A charging system for an electric vehicle may be constructed to include the transformer 1000, the allowed power quantity management apparatus 1100, the AC/DC converting system 2000, and the DC power delivery system 500a.

FIG. 3C exemplifies a case in which power grids have been separated from each other.

If a transformer that has been previously installed can handle power used for charging, power may be supplied by using the corresponding transformer without separate installation instead of the transformer 1000 in FIG. 3C. If a transformer that has been previously installed cannot handle power used for charging, power may be supplied through the installation of an additional transformer 1000.

In FIG. 3C, the AC/DC converting system 2000 may be one in number or may be constructed in a plural number. For example, the AC/DC converting system 2000 may be constructed in a plural number like first to fifth AC/DC converting systems 2010, 2020, 2030, 2040, and 2050 and may be constructed as one AC/DC converting system.

In the embodiment, an example in which the five AC/DC converting systems 2000 have been taken, but this is merely an example according to an embodiment of the present disclosure and the number of AC/DC converting systems may be greater or smaller than 5.

Furthermore, in the embodiment of FIG. 3C, the DC power delivery system 500a is connected to the AC/DC converting system 2000 in a one-to-one way, but this is merely an example according to an embodiment of the present disclosure. The DC power delivery system 500a may be connected to the AC/DC converting system 2000 in a one-to-many way.

In FIG. 3C, the first AC/DC converting system 2010 and the first DC power delivery system 510a, among the first to fifth AC/DC converting systems 2010, 2020, 2030, 2040, and 2050 and the first to fifth DC power delivery systems 510a, 520a, 530a, 540a, and 550a, have been described as an example.

Power which may be supplied by the first to fifth AC/DC converting systems 2010, 2020, 2030, 2040, and 2050 may be all the same. The amounts of power which may be supplied by the systems may be different from each other. Furthermore, the sizes of DC power of the request power manipulation units 3000 included in the first to fifth DC power delivery systems 510a, 520a, 530a, 540a, and 550a, respectively, may be all the same. The request power manipulation units 3000 may be constructed by using DC power having different sizes, if necessary.

In particular, in this case, the sizes of charging voltages in power, which are used electric vehicles that are sold on the market, may be various. Accordingly, the sizes of the charging voltages may be variously constructed when a system is constructed, if necessary. For example, if the sizes of charging voltages for electric vehicles are 800 V and 400 V, a system may be constructed by considering the ratio of the number of electric vehicles in which the two voltages are used.

The first and second request power manipulation units 3010 and 3020 include the first DC/DC converter group 41 and the open circuit connection switch 3012. The first DC/DC converter group 41 includes only the current fixed type D/Ds 3011. All of the current fixed type D/Ds 3011 may supply charging speeds (requested power) having the same size, but may supply charging speeds having different sizes. The charging speed (requested power) of each current fixed type D/D 3011 may be variously determined by considering a situation in a corresponding parking lot upon installation.

Furthermore, in FIG. 3C, an example in which all of the DC/DC converter groups 40 of the first and second request power manipulation units 3010 and 3020 include a first DC/DC converter group 4010 including only the current fixed type D/Ds 3011 has been taken, but this is a construction according to an embodiment of the present disclosure. The DC/DC converter groups 40 of the request power manipulation units 3000 may be all the same or different from each other. This may be variously determined by considering a situation in a corresponding parking lot upon installation.

There is an advantage in that a charging speed (requested power) can be provided from slow charging to quick charging using DC power in response to the selection of a charging wisher by variously constructing the current fixed type D/D 3011 of the first DC/DC converter group 41. There is an advantage in that a charging system that has been previously constructed can be expanded by additionally installing the AC/DC converting system 2000 and the request power manipulation unit 3000 when the number of electric vehicles is increased.

Furthermore, detailed structures of the request power manipulation unit 3000 of each of the first to fifth DC power delivery systems 510a, 520a, 530a, 540a, and 550a and the intra-parking lot power grid 5000 may be the same as detailed structures of the first request power manipulation unit 3010 and the first intra-parking lot power grid 5010, but may be differently constructed, if necessary.

The power grid 5000 may include a plurality of separated power grids. Referring to FIG. 3C, the first intra-parking lot power grid 5010 may include two separated power grids.

FIG. 3C is a diagram illustrating a case in which several AC/DC converting systems 2000 are constructed, several request power manipulation units 3000 are constructed in the AC/DC converting system 2000, and the first and second request power manipulation units 3010 and 3020 cannot deliver power unlike in FIG. 3B.

Furthermore, FIG. 3C is a diagram illustrating a case in which the request power manipulation unit 3000 is separately present in each of the first to fifth AC/DC converting systems 2010, 2020, 2030, 2040, and 2050 and the first to fifth AC/DC converting systems 2010, 2020, 2030, 2040, and 2050 and the request power manipulation unit 3000 are constructed outside the vicinity of a parking lot.

Furthermore, the embodiment is an embodiment according to the present disclosure illustrating a case in which the multi-connection switch 700 is constructed only on the parking surface 80 and one charging adapter 5015 can charge one electric vehicle.

Meanwhile, multiple edges which may form a contact to which three or more electric wires are selectively connected may be formed in the power grid 5000. The multi-connection switch 700 may be disposed at a selected edge among the edges. The multi-connection switches 700 may be connected to three or more electric wires of the power grid 5000. A connection path may be selectively formed by connecting some of the three or more electric wires.

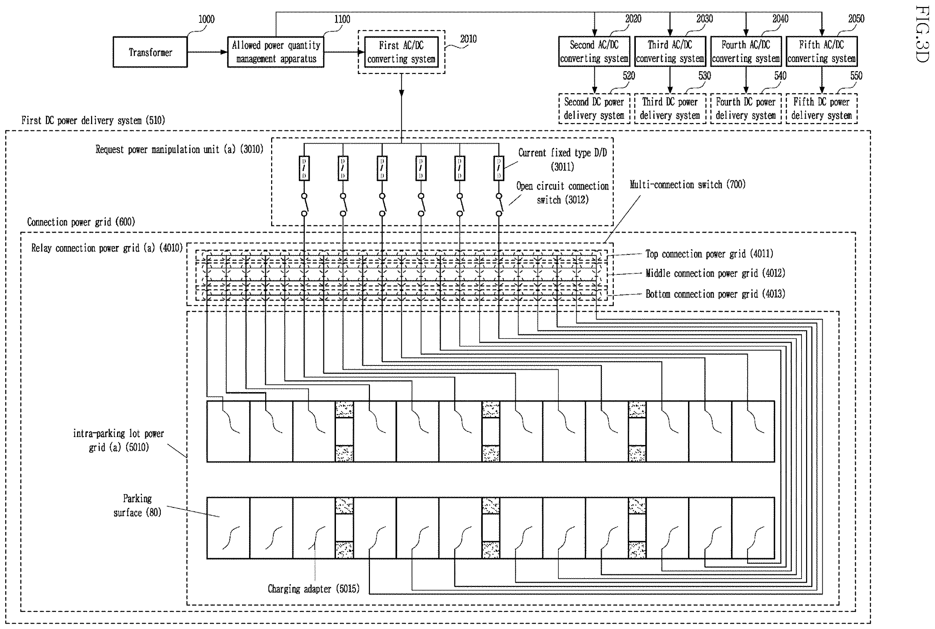

FIG. 3D is similar to FIG. 3A, but is a diagram illustrating an example of a case in which the multi-connection switch 700 is not present in a part or the entire space of the intra-parking lot power grid 5000 and a path is formed in the relay connection power grid 4000 disposed in a separate space as still another embodiment. Charging adapters 5015 installed in respective parking surfaces 80 that are present in a parking space in which the multi-connection switches 700 are not present are connected to electrical wires for supplying power through the formed path, respectively.

All of the electrical wires gather at a separate space for forming a path. Each of the electrical wires is connected to the relay connection power grid 4000 (or may be variously represented as a complex panel board or a multilateral panel board) including the multi-connection switches 700 and the electrical wires. The relay connection power grid 4000 forms a path from a charger to the parking surface 80 in response to a request from a charging wisher. Power that is supplied by the request power manipulation unit 3000 is supplied up to the parking surface 80 by the path formed in the relay connection power grid 4000.

A shape of the relay connection power grid 4000 may be constructed in various shapes, such as a quadrangle and a trapezoid, and may be different depending of a form of a space in which the relay connection power grid 4000 is installed and a construction of a multi-connection switch for forming a path.

FIG. 4A is a diagram illustrating an example of an implementation of the multi-connection switch 700.

Referring to FIG. 4A, the multi-connection switch 700 may include sockets 1410 to which different electrical wires are connected, internal wirings 1500 that connect the sockets 1410, a plurality of switches 1600 disposed in at least some of the internal wirings 1500, and a controller 1420 that selectively forms one or more connection paths to which two electrical wires, among a plurality of electric wires 750, 760, 770, and 780 connected to the multi-connection switch 700, are connected by operating the plurality of switches 1600.

The multi-connection switch 700 may include the switches 1600 for forming paths for the electrical wires, demultiplexers 1430 for controlling the switches 1600, LEDs 1440 for displaying paths being used, the controller 1420 that controls the demultiplexer 1430 and plays a role to communicate with the main control apparatus 6000, a communication line for communication with the main control apparatus 6000, and a power line and power unit for supplying power to the controller 1420. The LED 1440 for displaying a connection path may be provided as a number corresponding to the plurality of switches 1600.

Referring to FIG. 4A, the electrical wires 750, 760, 770, and 780 that are connected to the multi-connection switch 700 from the outside are connected to the internal wirings 1500 of the multi-connection switch 700. Three internal wirings (1510, 1520, 1530), (1550, 1520, 1560), (1560, 1540, 1510), and (1530, 1540, 1550) may be connected to the electrical wires 750, 760, 770, and 780, respectively.

Referring to FIG. 4A, two switches 1600 may be disposed between the two sockets 1410. That is, two switches 1600 may be disposed per path (1510, 1520, 1530, 1540, 1550, or 1560).

Each of the electrical wires 750, 760, 770, and 780 is connected the switch 1600 capable of selecting one of the three paths (1510, 1520, 1530), (1550, 1520, 1560), (1560, 1540, 1510), and (1530, 1540, 1550). Accordingly, the multi-connection switch 700 may form a total of six types of top-bottom (1520), left-right (1540), left-top (1510), left-bottom (1560), right-top (1530), and right-bottom (1550) paths depending on states of the switches 1600 connected to the respective electrical wires 750, 760, 770, and 780.

Furthermore, two paths may be formed to be not overlapped. Other switches that are connected to electrical wires connected when the six types of basic paths are formed and the three types of two paths are formed maintain an OFF state.

That is, when the state of another switch that is connected to an electrical wire becomes an ON state, there may be a problem in that power that is supplied through the electrical wire may be distributed to several paths, not one path. Accordingly, another switch that is connected to an electrical wire other than a switch that is used to form a path maintains the OFF state.

The external electrical wire 750 that is connected to a first socket 1410a is connected to a second socket 1410b and the external electrical wire 770 along the left-top (1510) path, is connected to a fourth socket 1410d and the external electrical wire 760 along the top-bottom (1520) path, and is connected to a third socket 1410c and the external electrical wire 780 along the right-top (1530) path.

The external electrical wire 770 that is connected to the second socket 1410b is connected to a first socket 1410a and the external electrical wire 750 along the left-top (1510) path, is connected to the third socket 1410c and the external electrical wire 780 along the left-right (1540) path, and is connected to the fourth socket 1410d and the external electrical wire 760 along the left-bottom (1560) path.

The external electrical wire 780 that is connected to the third socket 1410c is connected to the first socket 1410a and the external electrical wire 750 along the right-top (1530) path, is connected to the second socket 1410b and the external electrical wire 770 along the left-right (1540) path, and is connected to the fourth socket 1410d and the external electrical wire 760 along the right-bottom (1550) path.

The external electrical wire 760 that is connected to the fourth socket 1410d is connected to the first socket 1410a and the external electrical wire 750 along the top-bottom (1520) path, is connected to the third socket 1410c and the external electrical wire 780 along the right-bottom (1550) path, and is connected to the second socket 1410b and the external electrical wire 770 along the left-bottom (1560) path.

Meanwhile, when a voltage that is supplied through a power line is equal to an operating voltage of the controller 1420 or within an operating voltage range of the controller 1420, the power unit may be omitted. The LED 1440 may be omitted although the LED has been used to display a path that is being used.

Furthermore, various types of wired and wireless communication, such as USART, RS232, a CAN, a LAN, a LIN, WiFi, Bluetooth, and Zigbee, in addition to RS485 communication may be used as communication between the multi-connection switch 700 and the main control apparatus 6000.

**An** EV relay (DC contactor), etc. that is used in the charger of an electric vehicle may be used as the switch 1600. A separate switch suitable for the multi-connection switch 700 may be fabricated and used as the switch 1600. The switch 1600 may be selected based on an output voltage of the DC/DC converter that has been constructed in the request power manipulation unit 3000 and a maximum output current.

If the switch is made OFF in the state in which a high voltage and current flow, several problems may be caused in the switch because arc occurs. However, the charging system according to the present disclosure forms a path by previously controlling the multi-connection switch 700 before supplying power for charging, supplies the power by making ON the open circuit connection switch 3012 when the forming of the path is completed, and makes OFF the open circuit connection switch 3012 and releases the forming of the path after charging is completed. Accordingly, a problem, such as arc, can be prevented.

In FIG. 4A, the two switches are used in one path 1510, 1520, 1530, 1540, 1550, or 1560. Accordingly, if one switch breaks down in any path, a problem which may occur due to the breakdown of the switch can be prevented by controlling another switch.

According to an embodiment of the present disclosure, the switch 1600 may be controlled by using a device, such as the demultiplexer 1430. The multi-connection switch 700 is connected to the plurality of switches 1600 through control lines, and may include the plurality of demultiplexers 1430 for operating the switches 1600 under the control of the controller 1420.

As in FIG. 4C, a device, such as the demultiplexer 1430, may be omitted. The multi-connection switch 700 may be differently constructed depending on devices that are used to implement the multi-connection switch 700.

FIG. 4A is a diagram illustrating an embodiment according to the present disclosure. The multi-connection switch 700 may be variously implemented in addition to the illustrated construction.

FIG. 4B is a diagram illustrating an example in which only switches necessary to form paths are used in the construction of FIG. 4A. Referring to FIG. 4B, one switch 1600 may be disposed between two sockets 1410. That is, one switch 1600 may be disposed in one path 1510, 1520, 1530, 1540, 1550, or 1560.

In FIG. 4A, in order to prevent a problem such as breakdown, the switches have been additionally constructed within the multi-connection switch 700. If a system capable of preventing a breakdown problem or blocking a problem when the problem occurs is constructed in another place not the multi-connection switch 700, the switches may be constructed by only the number necessary to form paths as in FIG. 4B.

FIG. 4C is a diagram illustrating an example in which the demultiplexer 1430 has been omitted in the construction of FIG. 4B. The plurality of switches 1600 and the controller 1420 may be directly connected through control lines. The demultiplexer 1430 may be used if an I/O for controlling the switch 1600 by the controller 1420 is insufficient. If the I/O of the controller 1420 for controlling the switch 1600 is sufficient, the demultiplexer 1430 may be omitted as in FIG. 4C. Furthermore, if a switch control voltage level for operating the switch 1600 is different from the output voltage level of the I/O of the controller 1420, a circuit for operating the switch 1600 may be additionally constructed.

Furthermore, in FIGS. 4A to 4C, the sockets 1410a, 1410b, 1410c, and 1410d, the switch 1600, and electrical wires that are connected between the switches 1600 may be designed as a PCB power distribution. Separate electrical wires may be directly connected and used through soldering, etc., not the PCB power distribution, depending on the size of a current that flows into the electrical wires.

Each of the charging adapters 5015 may be disposed between two multi-connection switches 700. Furthermore, a plurality of charging adapters 5015 may be disposed between the two multi-connection switches 700.

FIG. 4D is a diagram illustrating an example of a multi-connection switch structure which has been constructed so that the number of switches and the number of paths are identically constructed and two lines can be connected according to still another embodiment of the present disclosure. The plurality of switches 1600 and the controller 1420 may be directly connected through control lines. Furthermore, in FIG. 4D, since the size of a current that flows into the multi-connection switch 700 is large, the plurality of switches 1600 and the controller 1420 may be constructed by using a separate line, not a PCB power distribution. In order to reduce contact resistance which occurs when the plurality of switches 1600 is connected, the plurality of switches 1600 and the controller 1420 may be connected in a bus bar type. FIG. 4D illustrates the inside of the multi-connection switch 700 that has been constructed by using a copper bus bar. The arrangement of the multi-connection switch 700 is merely an example according to the present disclosure and may be differently disposed, but may be constructed by using different types of materials capable of reducing contact resistance, not the copper bus bar.

Furthermore, in order to reduce contact resistance which occurs when the electrical wire and the copper bus bar are connected, various methods of extending a contact area by filling a space between the electrical wire and the copper bus bar with a metal filler may be used. For example, a method of lowering contact resistance by instantly spraying lead or an alloy (amalgam, etc.) having a relatively low melting point onto an empty space between the electrical wire and the copper bar that are brought into contact with each other at high pressure may be used.

Referring to FIG. 5, the charging adapter 5015 is connected between two multi-connection switches 700 through one line, but several charging adapters 5015 may be connected. In this case, the number of charging adapters 5015 is several. However, one charging adapter 5015, among the several charging adapters 5015, is actually used for charging, and other charging adapters 5015 may not be used for charging. In this case, the number of charging adapters 5015 is considered to be one although several charging adapters are indicated.

For example, if two charging adapters 5015 are physically connected between two multi-connection switches 700 and are connected to different charging target vehicles 9000, any one of the charging target vehicles 9000 may be first charged based on a charging end time set by each charging wisher, and the other charging target vehicle 9000 may be charged when the charging of the charging target vehicle 9000 is completed or the charging end time is reached. That is, although the charging adapter 5015 is connected to all of the charging target vehicles 9000, the charging target vehicles 9000 may be charged one by one according to their priorities.

Meanwhile, the charging adapters 5015 may be provided in a way to be detachable from the power grid 5000. For example, the charging adapters 5015 may be provided in a way to be detachable from a socket of the power grid 5000. A charging wisher may carry a charging adapter that is matched with a charging protocol of his or her electric vehicle in a trunk, etc., and may use the charging adapter by connecting the charging adapter to the power grid 5000.

Furthermore, one charging adapter 5015 may be installed in one parking surface 80, but one charging adapter 5015 may be installed two parking surfaces 80, if necessary. In this case, one charging adapter 5015 may be used to charge any one electric vehicle in the two parking surfaces 80.

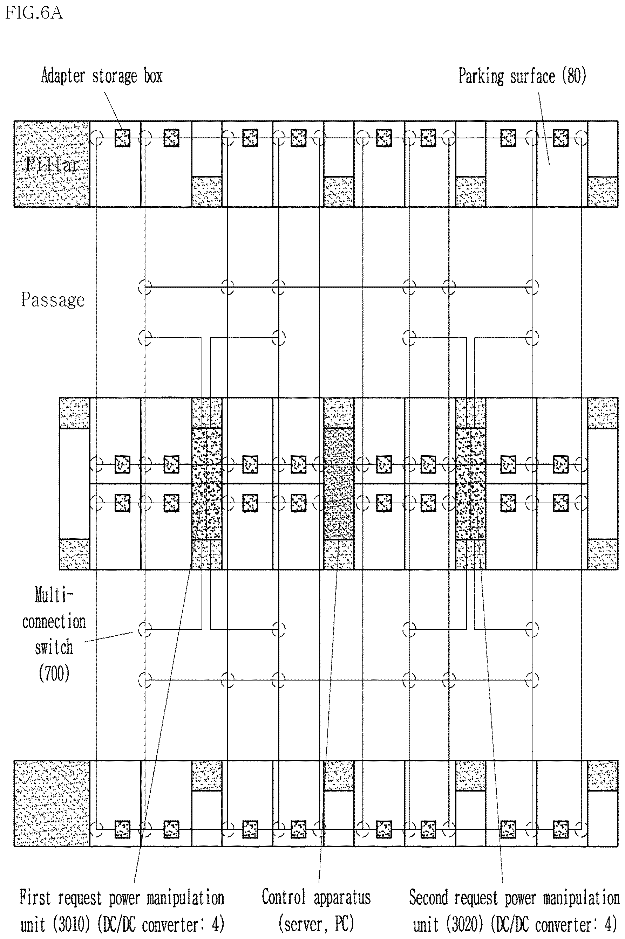

FIG. 6A is still another detailed embodiment of the present disclosure, and is a diagram illustrating an example in which 32 parking surfaces and 2 request power manipulation units have been independently constructed. In a charging system for an electric vehicle illustrated in FIG. 6A and a parking lot including the charging system, only an electric vehicle can be parked in the parking lot. A total of parking surfaces 80 is 32 surfaces, the number of multi-connection switches 700 used is 60, the number of D/Ds of the first request power manipulation unit 3010 is 4, and the number of D/Ds of the second request power manipulation unit 3020 is 4. The length of an electrical wire that is used to form the intra-parking lot power grid 5000 is about 998 m. The number of multi-connection switches 700 that is necessary to form a path at an arbitrary point is 4 on average, and is a minimum of about 2 to a maximum of about 6.

Furthermore, the multi-connection switch 700 is basically installed on the parking surface. However, in order to increase the number of cases for forming an optimum path, multi-connection switch 700 may be additionally installed on a location, such as a passage. In FIG. 6A, a total of 12 multi-connection switches 700 have been additionally installed to form paths.

The present embodiment may be used as a concept of an electric vehicle charging station exclusively for an electric vehicle.

The parking lot has been constructed to be 2.3 m X 5.0 m, that is, minimum criteria for a common type parking unit section and to have a 6-meter road and a 0.5-meter pillar according to right-angled parking criterion. This is merely one construction according to an embodiment of the present disclosure. Corresponding lengths of a parking lot may be changed according to criteria at the time of design. The parking lot may be designed according to minimum criteria for an extension type parking unit section not the minimum criteria for the common type parking unit section or may be designed greater than the minimum criteria for the common type parking unit section.

In order to measure a voltage drop according to the length of electrical wires, a voltage drop that occurs in the relay switch within the multi-connection switch 700, and a voltage drop attributable to contact resistance that occurs when the electrical wire and the multi-connection switch 700 are coupled, a total of three types of experiments were performed. The experiments were performed five times by using a 25SQ electrical wire and a ring type compression terminal, a 100SQ electrical wire and a ring type compression terminal, and a 100SQ electrical wire and a copper bus bar, and the voltage drops that occurred on average in the five experiments were measured in detail.

**[Table 1]**

| | Ring | | Terminal | | Compressed part | |
|---|---|---|---|---|---|---|
| | Internal diameter | External diameter | Total length | Length | Internal diameter | External diameter |
| 25SQ electrical wire and ring type compression | 8.5 mm | 16 mm | 32 mm | 11.5 mm | 7.5 mm | 10 mm |
| terminal used | | | | | | |
| 100SQ electrical wire and ring type compression terminal used | 12.9 mm | 24 mm | 49.5 mm | 19.5 mm | 15.6 mm | 20 mm |
| 100SQ electrical wire and copper bus bar used | 20x3 mm² | | | | | |

In the first experiment, a charging system using a three-wheel electric vehicle supplies a current of 15.5 A by using the 25SQ electrical wire and the ring type compression terminal. A measured voltage drop attributable to the electrical wire was measured as 0.01 V/m on average, and a voltage drop that occurred in one multi-connection switch 700 was measured as 0.05 V on average. Furthermore, when the 25SQ electrical wire was connected to one multi-connection switch 700, contact resistance of 0.0419 Q was generated, and a voltage drop measured accordingly was 0.65 V on average. A voltage drop per 25 m was measured as 0.94 V on average.

**[Table 2]**

| | | | | | | |
|---|---|---|---|---|---|---|
| 25SQ ring type compression terminal | Distance | | 25 m | 50 m | 75 m | 100 m |
| | Charger | DC output voltage | 79.0 V | 80.0 V | 80.9 V | 81.7 V |
| | | DC output current | 15.5 A | 15.5 A | 15.5 A | 15.5 A |
| | | Operating mode (CC/CV) | CC | CC | CC | CC |
| | Multi-connection switch | Front voltage | 78.19 V | 78.15 V | 78.06 V | 78.03 V |
| | | Back voltage | 78.14 V | 78.09 V | 78.01 V | 77.99 V |

In the second experiment, a charging system using an electric vehicle the charger supplied a current of 125 A by using the 100SQ electrical wire and the ring type compression terminal, a measured voltage drop according to the electrical wire was measured as 0.02 V/m on average, and a voltage drop that occurred in one multi-connection switch 700 was measured as 0.05 V on average. Furthermore, when the 100SQ electrical wire is connected to one multi-connection switch 700, contact resistance of 0.0204 Q was generated, and a voltage drop measured accordingly was measured as 2.55 V on average. A voltage drop per 25 m was measured as 3.1 V on average.

**[Table 3]**

| | | | | | | |
|---|---|---|---|---|---|---|
| 100SQ ring type compression terminal | Distance | | 25 m | 50 m | 75 m | 100 m |
| | Charger | DC output voltage | 388.4 V | 391.5 V | 394.7 V | 397.8 V |
| | | DC output current | 125 A | 125 A | 125 A | 125 A |
| | | Operating mode (CC/CV) | CC | CC | CC | CC |
| | Multi-connection switch | Front voltage | 385.29 V | 385.22 V | 385.04 V | 384.85 V |
| | | Back voltage | 385.24 V | 385.16 V | 384.99 V | 384.81 V |

In the third experiment, a charging system using a charger for an electric vehicle supplied a current of 125 A by using the 100SQ electrical wire and the copper bus bar. A measured voltage drop according to the electrical wire was measured as 0.02 V/m on average. A voltage drop that occurred in one multi-connection switch 700 was measured as 0.05 V on average. Furthermore, when the 100SQ electrical wire was connected to one multi-connection switch 700, contact resistance of 0.0105 Q was generated, and a voltage drop measured accordingly was measured as 1.31 V on average. A voltage drop per 25 m was measured as 1.86 V on average. The contact resistance may be different depending on the thickness of an electrical wire and a contact area of a compression terminal.

**[Table 4]**

| | | | | | | |
|---|---|---|---|---|---|---|
| 100SQ copper bus bar | Distance | | 25 m | 50 m | 75 m | 100 m |
| | Charger | DC output | 390.1 V | 391.7 V | 393.6 V | 395.4 V |
| | | voltage | | | | |
| | | DC output current | 125 A | 125 A | 125 A | 125 A |
| | | Operating mode (CC/CV) | CC | CC | CC | CC |
| | Multi-connection switch | Front voltage | 388.25 V | 388.04 V | 387.52 V | 387.19 V |
| | | Back voltage | 388.19 V | 387.99 V | 387.47 V | 387.14 V |

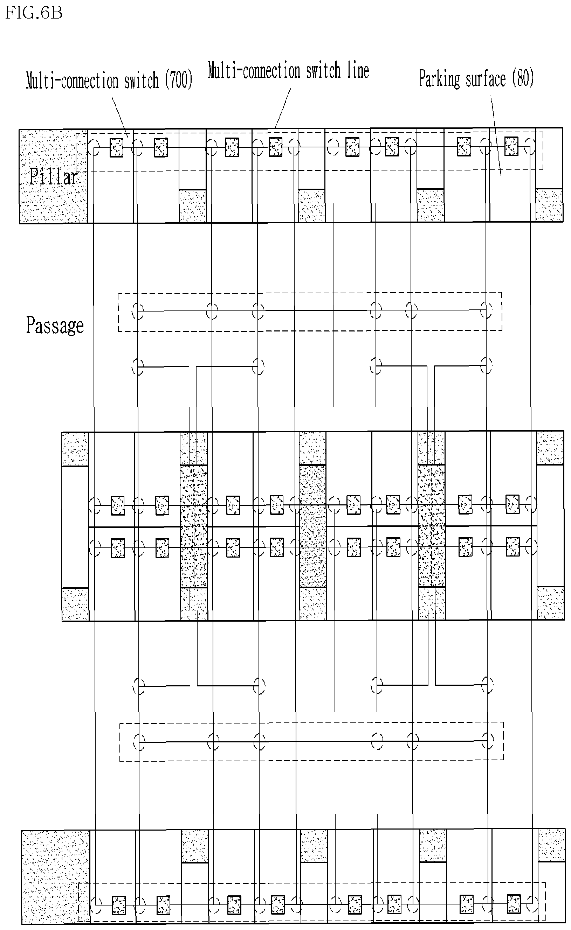

Furthermore, an average length of an electrical wire that is used to form a path is a minimum of 8 m to a maximum of 25 m, and each relay has a voltage drop of 0.05 V in about 0.16 V to about 0.5 V. A voltage drop according to the multi-connection switch 700, a voltage drop according to the length of the electrical wire, and a voltage drop according to the relay were measured to a level in which the voltage drop can be sufficiently compensated for. Furthermore, in the example, the parking lot may be a parking lot in a multiplex house, such as an apartment or a villa, a pay/free parking lot, a public parking lot, a parking lot in a service area, a commercial charging station, etc. If a charging system is installed in an outdoor parking lot, the charging system may be constructed by separately adding new renewable energy generation, such as solar energy generation, in addition to the charging system according to an embodiment of the present disclosure. FIG. 6B is a diagram illustrating an example of a construction in which the multi-connection switches 700 disposed in adjacent parking surfaces according to an embodiment of the present disclosure are bound by one line and managed as a multi-connection switch line unit. In the case of FIG. 6B, since the adjacent multi-connection switches 700 are horizontally disposed, one horizontal line is bound and managed as one multi-connection switch line. In FIG. 6B, a maximum of 32 multi-connection switch lines may be bound and used as one line for smooth communication although the multi-connection switch lines are adjacent to each other. In the case of the multi-connection switch 700 that is disposed in a passage, adjacent multi-connection switches 700 are bound and managed as one line, and corresponding multi-connection switch lines form a path or the forming of a path by the multi-connection switch lines is released by controlling the multi-connection switches 700 through communication with a control apparatus (a server, a PC, etc.). It has been said that a maximum of the multi-connection switch lines is 32, but this is merely an example according to an embodiment and the number of multi-connection switch lines may be greater or smaller than 32.

For the multi-connection switch line, various methods for wired communication or wireless communication, such as RS485, P-NET, R-NET, PLC, a CAN, a LAN, a LIN, Bluetooth, Zigbee, and Beacon, may be used as a communication method that is used for communication between the multi-connection switches 700 or communication with the multi-connection switch line and the control apparatus (a server or a PC).

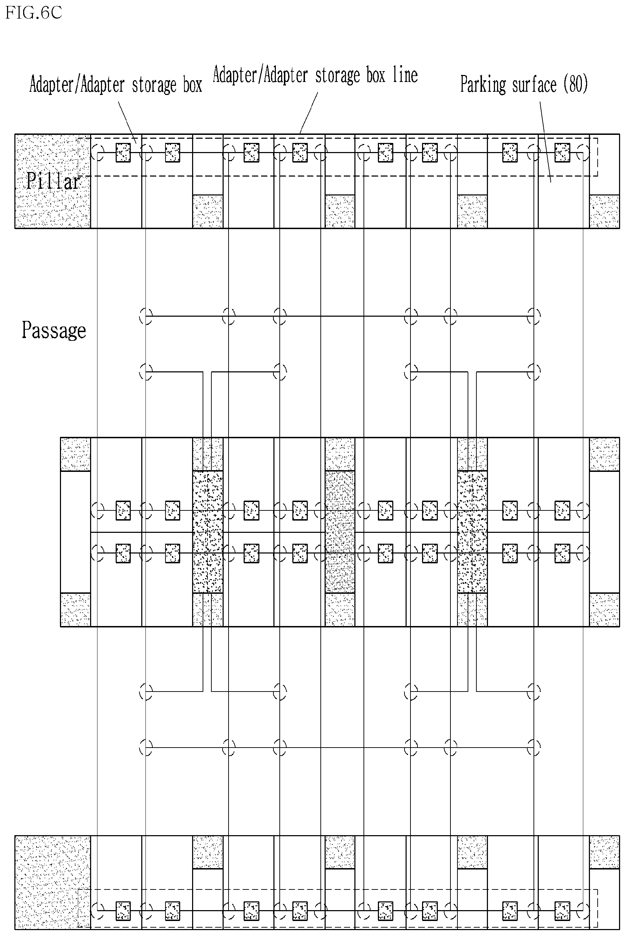

FIG. 6C is a diagram illustrating an example of a construction in which the adapters or the adapter storage boxes disposed on adjacent parking surfaces according to an embodiment of the present disclosure are bound by one line and managed in an adapter or adapter storage box line unit.

If a charging system for an electric vehicle is constructed as in FIG. 6A, the adapters or the adapter storage boxes are installed on the parking surfaces, respectively, one by one. The adapter may be directly installed without the adapter storage box, but the adapter storage box constructed to include a separate adapter may be installed. The adapter or the adapter storage box may play a role to supply power supplied via a path that is formed by using the multi-connection switch 700 from a charger to an electric vehicle or to block the power.

The adapter or the adapter storage box consistently monitors electric vehicle battery information, etc. through a communication line of the adapter connected to the electric vehicle, and continuously exchanges communication, such as transmitting the electric vehicle battery information to the control apparatus (a server or a PC). If an urgent situation occurs or a separate charging stop request, etc. is received, the adapter or the adapter storage box needs to rapidly exchange information with the control apparatus (a server or a PC). In this case, in FIG. 6C, four adapters or adapter storage boxes are bound into one and manage in an adapter or adapter storage box line. Four adapters or adapter storage box lines have been described, but this is merely an example according to an embodiment and the number of adapters or adapter storage box lines may be greater or smaller than 4.

For the adapter or the adapter storage box line, various methods for wired communication or wireless communication, such as RS485, P-NET, R-NET, PLC, a CAN, a LAN, a LIN, Bluetooth, Zigbee, and Beacon, may be used as a communication method that is used for communication between the adapters or the adapter storage boxes or communication with the adapter or the adapter storage box line and the control apparatus (a server or a PC).

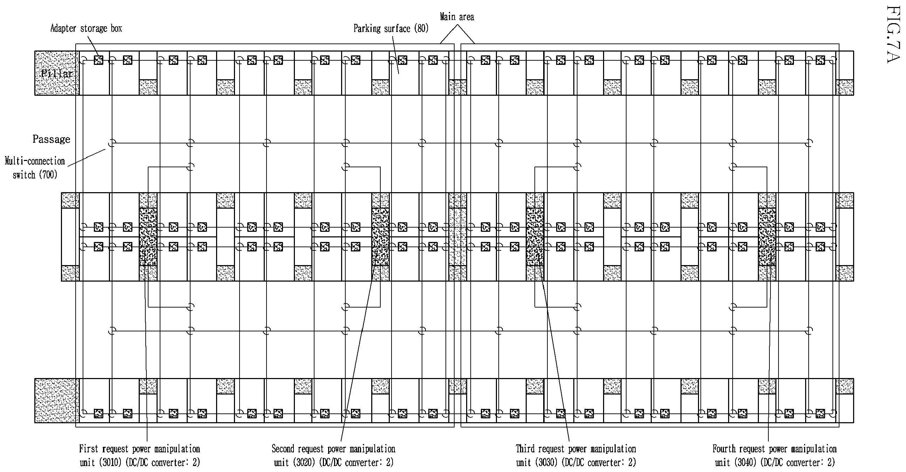

FIG. 7A is a diagram illustrating an example in which two request power manipulation units according to an embodiment of the present disclosure are independently constructed. In a charging system for an electric vehicle illustrated in FIG. 7A and a parking lot including the charging system, an electric vehicle and an internal combustion engine vehicle, etc. can be freely parked. A total number of parking surfaces 80 is 80 surfaces, the number of multi-connection switches 700 used is 116, the number of D/Ds of the first request power manipulation unit 3010 is two, the number of D/Ds of the second request power manipulation unit 3020 is two, the number of D/Ds of the third request power manipulation unit 3030 is two, and the number of D/Ds of the fourth request manipulation unit 3040 is two. The length of an electrical wire that is used to form the intra-parking lot power grid 5000 is about 2,315 m. The number of multi-connection switches 700 that are necessary to form a path at an arbitrary point is 6 on average 6, and is 2 to a minimum to 10 to a maximum.

Furthermore, the multi-connection switch 700 is basically installed on the parking surface, but may be additionally installed in a passage, etc. in order to increase the number of cases for forming an optimum path. In FIG. 7A, a total of 20 multi-connection switches 700 have been additionally installed to form a path.

The parking lot has been constructed to be 2.3 m X 5.0 m, that is, minimum criteria for a common type parking unit section and to have a 6-meter road and a 0.5-meter pillar according to right-angled parking criterion. This is merely one construction according to an embodiment of the present disclosure. Corresponding lengths of a parking lot may be changed according to criteria at the time of design. The parking lot may be designed according to minimum criteria for an extension type parking unit section not the minimum criteria for the common type parking unit section or may be designed greater than the minimum criteria for the common type parking unit section.

Furthermore, in the example, the parking lot may be a parking lot in a multiplex house, such as an apartment or a villa, a pay/free parking lot, a public parking lot, a parking lot in a service area, a commercial charging station, etc. If a charging system is installed in an outdoor parking lot, the charging system may be constructed by separately adding new renewable energy generation, such as solar energy generation, in addition to the charging system according to an embodiment of the present disclosure.

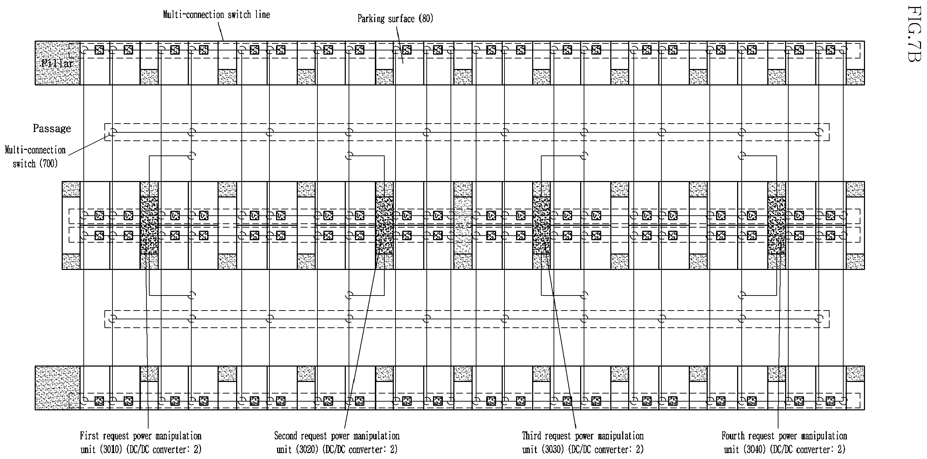

FIG. 7B is a diagram illustrating an example of a construction in which the multi-connection switches 700 disposed in adjacent parking surfaces according to an embodiment of the present disclosure are bound by one line and managed as a multi-connection switch line unit. In the case of FIG. 7B, since the adjacent multi-connection switches 700 are horizontally disposed, one horizontal line is bound and managed as one multi-connection switch line. In FIG. 7B, a maximum of 32 multi-connection switch lines may be bound and used as one line for smooth communication although the multi-connection switch lines are adjacent to each other. In the case of the multi-connection switch 700 that is disposed in a passage, adjacent multi-connection switches 700 are bound and managed as one line, and corresponding multi-connection switch lines form a path or the forming of a path by the multi-connection switch lines is released by controlling the multi-connection switches 700 through communication with a control apparatus (a server, a PC, etc.). It has been said that a maximum of the multi-connection switch lines is 32, but this is merely an example according to an embodiment and the number of multi-connection switch lines may be greater or smaller than 32.

For the multi-connection switch line, various methods for wired communication or wireless communication, such as RS485, P-NET, R-NET, PLC, a CAN, a LAN, a LIN, Bluetooth, Zigbee, and Beacon, may be used as a communication method that is used for communication between the multi-connection switches 700 or communication with the multi-connection switch line and the control apparatus (a server or a PC).

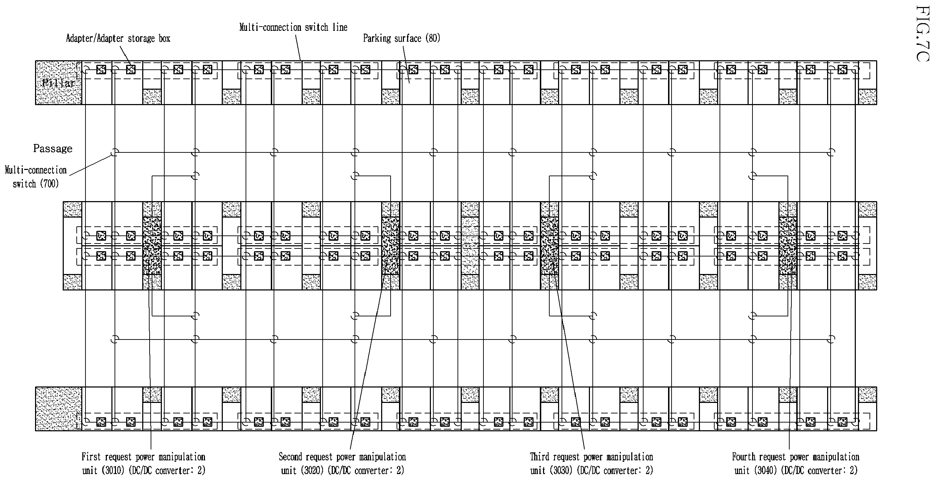

FIG. 7C is a diagram illustrating an example of a construction in which the adapters or the adapter storage boxes disposed in adjacent parking surfaces according to an embodiment of the present disclosure are bound by one line and managed in an adapter or adapter storage box line unit.

If a charging system for an electric vehicle is constructed as in FIG. 7A, the adapters or the adapter storage boxes are installed on the parking surfaces, respectively, one by one. The adapter may be directly installed without the adapter storage box, but the adapter storage box constructed to include a separate adapter may be installed. The adapter or the adapter storage box may play a role to supply, to an electric vehicle, power supplied via a path that is formed by using the multi-connection switch 700 from a charger or block the power.

The adapter or the adapter storage box consistently monitors electric vehicle battery information, etc. through a communication line of the adapter connected to the electric vehicle, and continuously exchanges communication, such as transmitting the electric vehicle battery information to the control apparatus (a server or a PC). If an urgent situation occurs or a separate charging stop request, etc. is received, the adapter or the adapter storage box needs to rapidly exchange information with the control apparatus (a server or a PC). In this case, in FIG. 6C, four adapters or adapter storage boxes are bound into one and manage in an adapter or adapter storage box line. Four adapters or adapter storage box lines have been described, but this is merely an example according to an embodiment and the number of adapters or adapter storage box lines may be greater or smaller than 4.

For the adapter or the adapter storage box line, various methods for wired communication or wireless communication, such as RS485, P-NET, R-NET, PLC, a CAN, a LAN, a LIN, Bluetooth, Zigbee, and Beacon, may be used as a communication method that is used for communication between the adapters or the adapter storage boxes or communication with the adapter or the adapter storage box line and the control apparatus (a server or a PC).

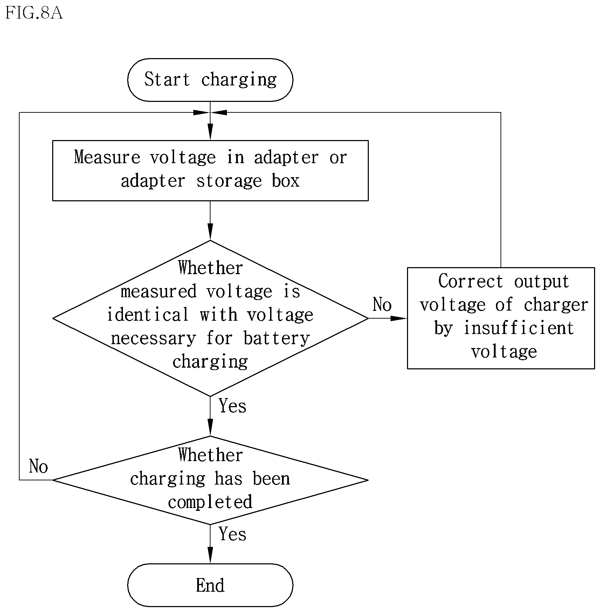

FIG. 8A is a diagram illustrating a flowchart of a method of compensating for a voltage drop that is different depending on the forming of a path in a charging system for an electric vehicle according to the present disclosure. When a charging path is formed and charging is started in the system, the system measures a voltage in the adapter or the adapter storage box. The system compares the measured voltage with a battery voltage that is necessary to charge an electric vehicle connected to the system. When the measured voltage is higher or lower than the battery voltage necessary for the charging, the charger adjusts an insufficient voltage by using the control apparatus (a server or a PC). The charger is constructed to adjust its output like 370 V to 410 V, for example, not a fixed voltage. When a voltage measured in the adapter or the adapter storage box is low, the charger supplies a voltage by adding an insufficient voltage to the voltage. When a voltage measured in the adapter or the adapter storage box is high, the charger supplies a voltage by subtracting an exceeded voltage from the voltage.

A voltage is continuously measured in the adapter or the adapter storage box until the charging is completed. When a change in the voltage occurs, the output voltage of the charger is continuously adjusted. When the charging is completed, the method of compensating for a voltage drop is terminated because the output voltage of the charger is no longer corrected.

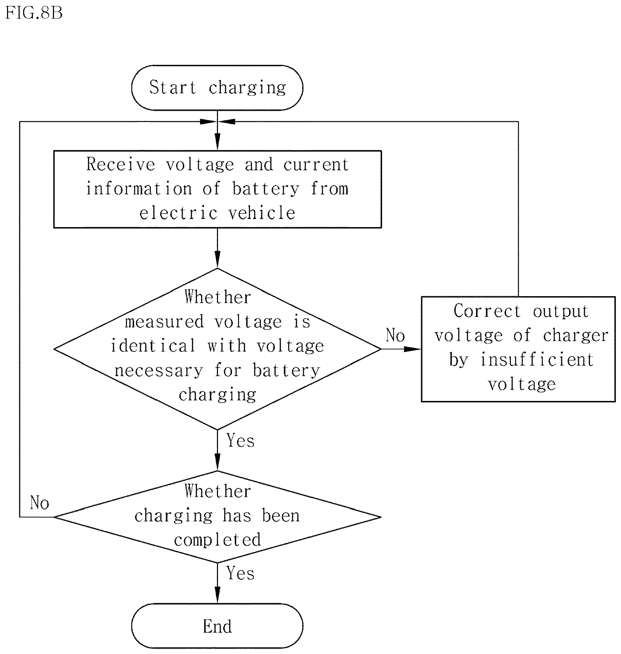

FIG. 8B is a diagram illustrating a flowchart of a method of compensating for a voltage drop that is different depending on the forming of a path in a charging system for an electric vehicle according to still another embodiment. When a charging path is formed and charging is started in the system, the system receives information of a battery, such as a voltage and a current, from an electric vehicle connected to the charging adapter, and compares the received voltage with a battery voltage necessary to charge the electric vehicle. When the received voltage is higher or lower than the battery voltage necessary for the charging, the charger adjusts an insufficient voltage by the control apparatus (a server or a PC).

The charger is constructed to adjust its output like 370 V to 410 V, for example, not a fixed voltage. When a voltage received from the battery is lower than a voltage necessary to charge the battery, the charger supplies a voltage by adding an insufficient voltage to the voltage. When the voltage received from the battery is higher than the voltage necessary to charge the battery, the charger supplies a voltage by subtracting an exceeded voltage from the voltage.

A voltage is continuously measured in the adapter or the adapter storage box until the charging is completed. When a change in the voltage occurs, the output voltage of the charger is continuously adjusted. When the charging is completed, the method of compensating for a voltage drop is terminated because the output voltage of the charger is no longer corrected.

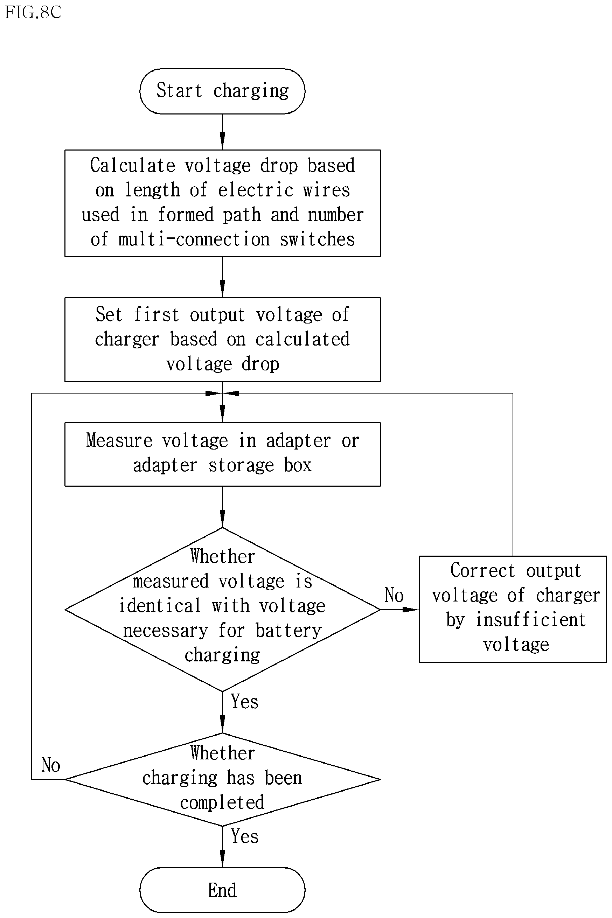

FIG. 8C is a diagram illustrating a flowchart of a method of compensating for a voltage drop that is different depending on the forming of a path in a charging system for an electric vehicle according to still another embodiment. When a charging path is formed and charging is started in the system, the system sets an output voltage that is supplied by the first charger by calculating a voltage drop based on the length of an electrical wire that is used in a formed path and the number of multi-connection switches.

The output voltage of the first charger is previously calculated, set, and supplied. Accordingly, there is an advantage in that a process of adjusting the output voltage of the charger based on a voltage drop can be performed more rapidly compared to FIG. 8A.

Thereafter, the system measures a voltage in the adapter or the adapter storage box, and compares the measured voltage with a battery voltage that is necessary to charge an electric vehicle connected to the system. When the measured voltage is higher or lower than the battery voltage necessary for the charging, the charger adjusts an insufficient voltage by using the control apparatus (a server or a PC).

The charger is constructed to adjust its output like 370 V to 410 V, for example, not a fixed voltage. When a voltage measured in the adapter or the adapter storage box is low, the charger supplies a voltage by adding an insufficient voltage to the voltage. When a voltage measured in the adapter or the adapter storage box is high, the charger supplies a voltage by subtracting an exceeded voltage from the voltage.

A voltage is continuously measured in the adapter or the adapter storage box until the charging is completed. When a change in the voltage occurs, the output voltage of the charger is continuously adjusted. When the charging is completed, the method of compensating for a voltage drop is terminated because the output voltage of the charger is no longer corrected.

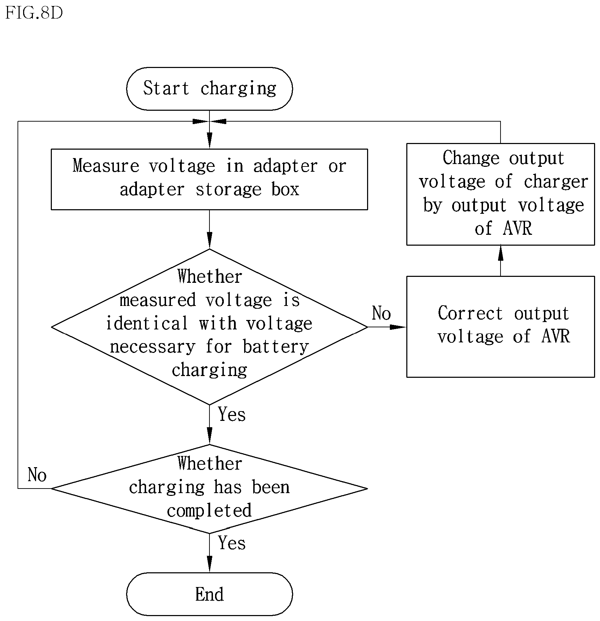

FIG. 8D is a diagram illustrating a flowchart of a method of compensating for a voltage drop that is different depending on the forming of a path in a charging system for an electric vehicle according to still another embodiment. When the charging system according to the present disclosure is constructed, basically, an automatic voltage regulator (AVR) is additionally constructed between the transformer and the AC/DC converting system 2000. Accordingly, a voltage drop can be compensated for by using the automatic voltage regulator (AVR), without compensating for a voltage drop in the charger as in FIG. 9A.

When a charging path is formed and charging is started in the system, the system measures a voltage in the adapter or the adapter storage box. The system compares the measured voltage with a battery voltage that is necessary to charge an electric vehicle connected to the system. When the measured voltage is higher or lower than the battery voltage necessary for the charging, the control apparatus (a server or a PC) transmits a control signal for an insufficient voltage to the automatic voltage regulator (AVR). The automatic voltage regulator (AVR) may adjust the size of an AC voltage that is output, in response to the control signal received from the control apparatus (a server or a PC). Accordingly, the size of a DC voltage that is converted in the AC/DC converting system 2000 and the size of the output voltage of the charger may be adjusted.

The output of the charger is not a fixed voltage. For example, if a voltage that is output by the automatic voltage regulator (AVR) is 380 V to 420 V, the output voltage of the AC/DC converting system 2000 is 370 V to 410 V, and the corresponding output of the charger is 370 V to 410 V. Accordingly, the charger may be constructed to adjust its output voltage based on the size of a varied voltage of the automatic voltage regulator (AVR) that is input to the charger via the AC/DC converting system 2000. When a voltage measured in the adapter or the adapter storage box is low, the automatic voltage regulator (AVR) supplies a voltage by adding an insufficient voltage to the voltage. When a voltage measured in the adapter or the adapter storage box is high, the automatic voltage regulator (AVR) supplies a voltage by subtracting an exceeded from the voltage.

Furthermore, in the embodiment, it has been described that the output voltage of the automatic voltage regulator (AVR) is 380 V to 420 V, the output voltage of the AC/DC converting system 2000 is 370 V to 410 V, and the output voltage of the charger is 370 V to 410 V, for example. These are merely numerical values for a description of the present disclosure, and the output voltages may be different, if necessary.

Furthermore, in the embodiment, it has been described that the automatic voltage regulator (AVR) has been constructed independently of the AC/DC converting system 2000 as an example. However, this is merely a construction according to the present disclosure, and the automatic voltage regulator (AVR) may be constructed to be included in the AC/DC converting system 2000.

A voltage is continuously measured in the adapter or the adapter storage box until the charging is completed. When a change in the voltage occurs, the output voltage of the automatic voltage regulator (AVR) is continuously adjusted. When the charging is completed, the method of compensating for a voltage drop is terminated because the output voltage of the automatic voltage regulator (AVR) is no longer corrected.

FIG. 9 illustrates a construction of the DC/DC converter. The request power manipulation unit 3000 may be constructed to include a current fixed type D/D 3021, a current fixed type D/D 3022 for a parallel connection, an open circuit connection switch 3023, and the multi-connection switch 700.

The second DC/DC converter group 42 in FIG. 9 may supply more various charging speeds (requested power) through a combination of two D/Ds by connecting the current fixed type D/D 3022 for a parallel connection to the current fixed type D/D 3021 in parallel, in order to supplement a disadvantage in which only a charging speed (requested power) which may be supplied by the first DC/DC converter group 41 including only the current fixed type D/D 3011 can be supplied.

Through control of the multi-connection switch 700, a charging speed (requested power) that is supplied by the current fixed type D/D 3022 for a parallel connection may be supplied by adding the charging speed to a charging speed (requested power) of the current fixed type D/D 3021.

The current fixed type D/D 3021 and the current fixed type D/D 3022 for a parallel connection may be constructed to supply charging speeds (requested power) having various sizes. There is an advantage in that a charging speed (requested power) that is desired by a charging wisher can be supplied as much as possible through a combination of charging speeds (requested power) that are variously constructed as described above.

The number of current fixed type D/Ds 3021 and the number of current fixed type D/Ds 3022 for a parallel connection may be different depending on the number of vehicles which can be simultaneously charged in a charging system according to the present disclosure.

In a charging process of FIG. 9, the current fixed type D/D 3021 of the second DC/DC converter group 42 may be selected in response to a charging speed (requested power) of a charging wisher, or a charging speed (requested power) that is requested by a charging wisher may be selected through a combination of the current fixed type D/D 3021 and the current fixed type D/D 3022 for a parallel connection.

Next, the intra-parking lot power grid 5000 forms an optimal path up to a location of the charging target vehicle 9000. When the forming of the path is completed, the charging speed (requested power) may be supplied by making ON the open circuit connection switch 3012 of the request power manipulation unit 3000.

FIGS. 10A to 10D are diagrams illustrating the number of selectable paths according to forms of the power grid according to an embodiment of the present disclosure. FIGS. 10A to 10D illustrate examples of triangle, quadrangle, hexagon, and hexahedron structures. The forms are merely examples according to an embodiment of the present disclosure, and the power grid may be constructed as various three-dimensional structures, such as a polygon such as a pentagon or a heptagon, and a regular tetrahedron.

As FIGS. 10A to 10D, the number of selectable output paths along which an electrical wire corresponding to an input path, among electrical wires connected to the multi-connection switch 700, may be selected is the same as the number of remaining electrical wires except the electrical wire corresponding to the input path. If the number of electrical wires connected to the multi-connection switches 700 is n and the number of selectable paths is x, x has a range of 1 to n-1.

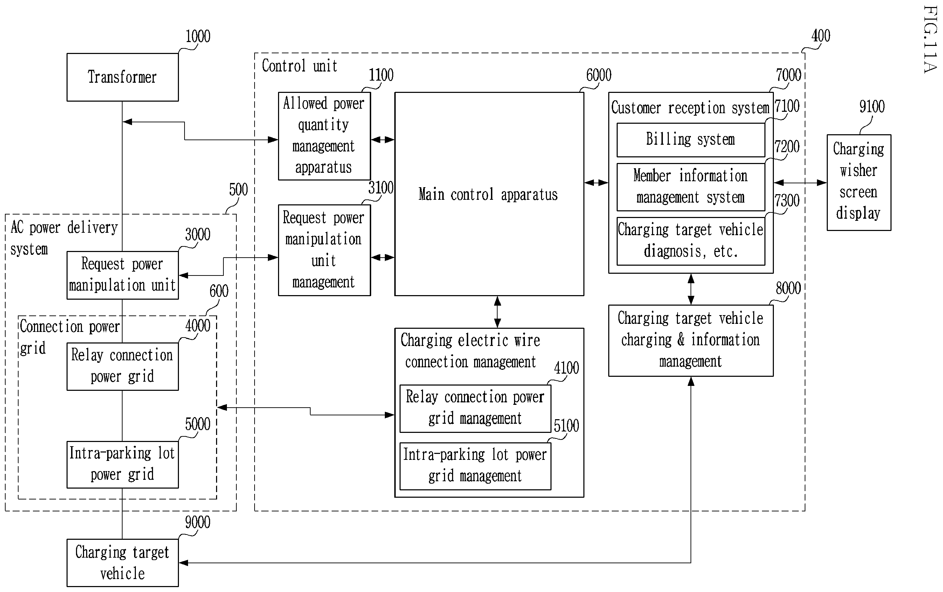

FIG. 11A illustrates a method of performing charging by using the AC power delivery system having relatively low-speed charging compared to DC by using the multi-connection switch, that is, a core of the present disclosure, and a network type power grid. As illustrated in FIG. 11A, the transformer 1000, an AC power delivery system 5500, the charging target vehicle 9000, the charging wisher screen display 9100, and a control unit 400 are included.

The size of an AC voltage that is transformed by the transformer 100 may be different depending on the size of an AC voltage of power generated by a power plant, which is used by the AC power delivery system 5500. The size of an AC voltage that is transformed is determined by considering transformation efficiency, etc.

Furthermore, in an embodiment of the present disclosure, AC power that is generated by a power plant is basically described, but pieces of equipment for converting supplied DC power may be included if the power is supplied to high voltage DC transmission (HVDC) that recently attracts attention.

When FIGS. 11A and 1 are compared, in FIG. 1, the request power manipulation unit has been constructed by using a D/D using DC power. In contrast, in FIG. 11A, the request power manipulation unit has been constructed by using an AC/AC converter using AC power.

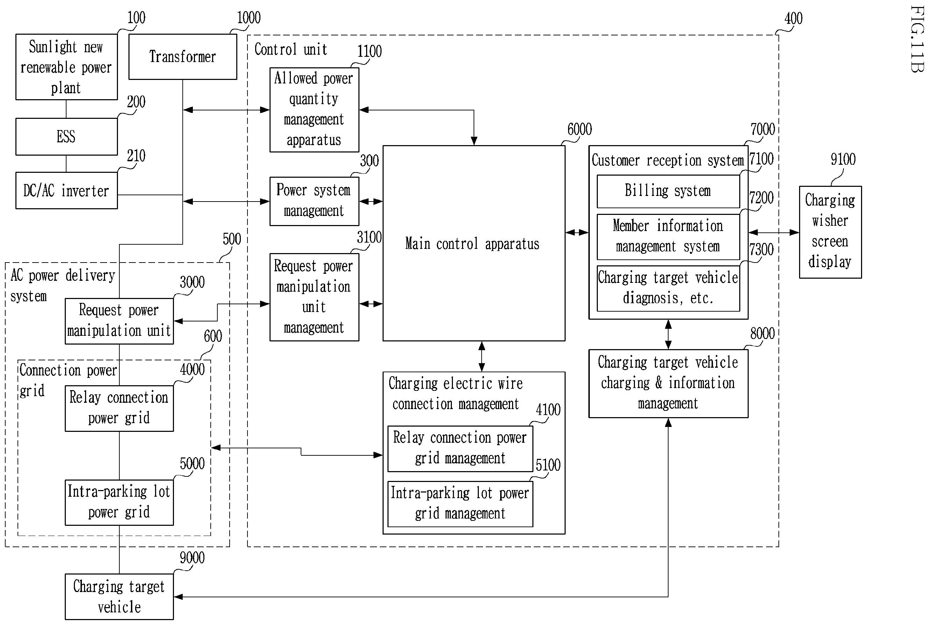

Most of the system in FIG. 11B is the same as the system of FIG. 11A. However, a new renewable power plant 100, such as sunlight, an ESS 200, a DC/AC inverter 210, and a power system management 300 are additionally constructed. FIG. 11B illustrates an overall block diagram of the system to which new renewable energy has been coupled.

The new renewable power plant 100, such as sunlight, may include new renewable power plants, such as solar energy generation and wind power generation. Solar energy generation is described as an example. Solar energy generation is a generation method of generating power by converting sunlight into DC electricity, and can generate power by using a solar panel to which several solar cells have been attached.

The solar panel has its output voltage determined depending on a construction of the solar cells and has a different current generated depending on the intensity of light. Power that is generated depending on the intensity of light is continuously changed. The charging system according to the present disclosure needs to supply a charging speed (requested power) requested by a charging wisher, and can supply a stable charging speed (requested power) by storing power generated by the solar energy generation in the ESS 200.

If power generated as in the solar energy generation is DC, the power is converted and stored in accordance with a charging voltage of the ESS 200 by using a DC/DC converter. If power generated as in the wind power generation is AC, the power is stored by using an AC/DC converter. In the example, the solar energy generation and the wind power generation have been described as examples, but the present disclosure is not limited to a corresponding generation method and various types of new renewable generation may be used.

The ESS 200 means an energy storage system, and may include several apparatuses for constructing the ESS 200, such as a battery, a battery management system (BMS), and a power management system (PMS). Apparatuses may be added or omitted if necessary.

The ESS 200 may be charged with new renewable energy, and may be charged during daytime when solar energy generation, for example, is used, but may be charged with power that is supplied by the transformer 1000 if the ESS cannot be charged normally at night or in a dark day or in a time zone in which electric charges are cheap.

Furthermore, the output voltage of the battery of the ESS 200 is DC, and may be supplied after being converted into AC power that is used in the AC power delivery system 500 by using the DC/AC inverter 210. In order to charge the battery of the ESS 200 with power that is supplied by the transformer 1000, an AC/DC converter may be additionally constructed.

The DC/AC inverter 210 is used to convert DC power of the ESS 200 into an AC. In order to charge the battery of the ESS 200 with power that is supplied by the transformer 1000, an AC/DC converter may be additionally constructed.

The power system management 300 plays a role to control power to be used according to circumstances, such as supplying power of the transformer 1000 to the AC power delivery system 500 or supplying energy stored in the ESS 200 to the AC power delivery system 500.

Furthermore, the power system management 300 may charge the battery of the ESS 200 with power that is supplied by the transformer 1000 when the amount of remaining charging power of the ESS 200 is small. In contrast, the power system management 300 performs control, such as selling energy stored in the ESS 200 to an electricity supply company in a time zone in which electric charges are expensive.

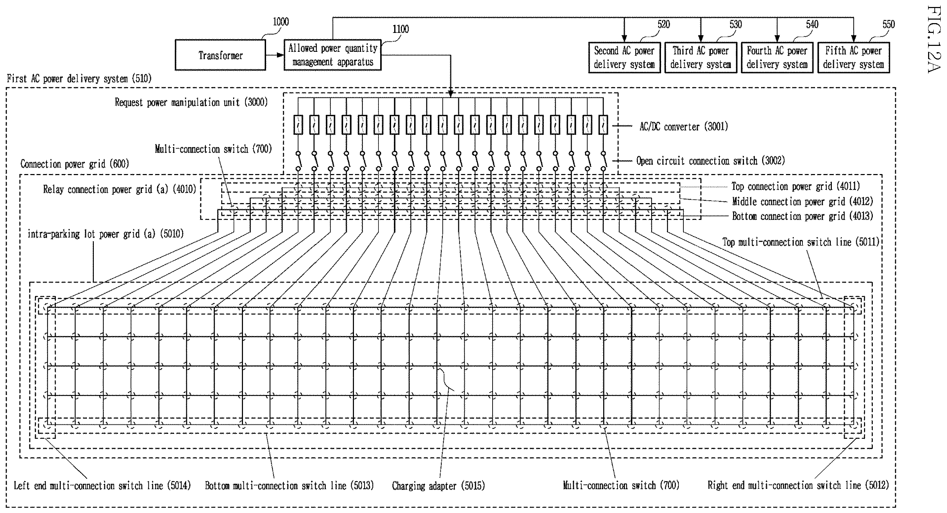

FIG. 12A represents a general structure from the transformer 1000 to a charging adapter 5015 at the place where the charging target vehicle 9000 has been disposed according to an embodiment of the present disclosure, as an example, and includes the transformer 1000, the allowed power quantity management apparatus 1100, and the AC power delivery system 500.

In FIG. 12A, the AC power delivery system 5500 has a construction in which first to fifth AC power delivery systems 5510, 5520, 5530, 5540, and 5550 are connected to the allowed power quantity management apparatus.

Five AC power delivery systems 5500 have been constructed, but this is merely an example according to an embodiment of the present disclosure and the number of AC power delivery systems may be greater or smaller than 5.

In FIG. 12A, the first AC power delivery system 5510, among the first to fifth AC power delivery systems 5510, 5520, 5530, 5540, and 5550, has been described as an example.

In the first to fifth AC power delivery systems 5510, 5520, 5530, 5540, and 5550, AC power having the same size may be used as AC power of the AC/AC converter 3001. AC power having different sizes may be used, if necessary.

In particular, in this case, a voltage of a power used may be variously generated and used, if necessary, by those skilled in the art if the sizes of standard voltages of electric vehicles that are sold on the market are variously different. For example, if charging standard voltages of electric vehicles are 220 V and 380 V, all the charging standard voltages may be accommodated by considering the ratio of the number of vehicles of the two vehicles.

Furthermore, detailed structures of the request power manipulation units 3000, relay connection power grids 4000, and intra-parking lot power grids 5000 of the first to fifth AC power delivery systems 5510, 5520, 5530, 5540, and 5550 may be the same or may be differently constructed, if necessary.

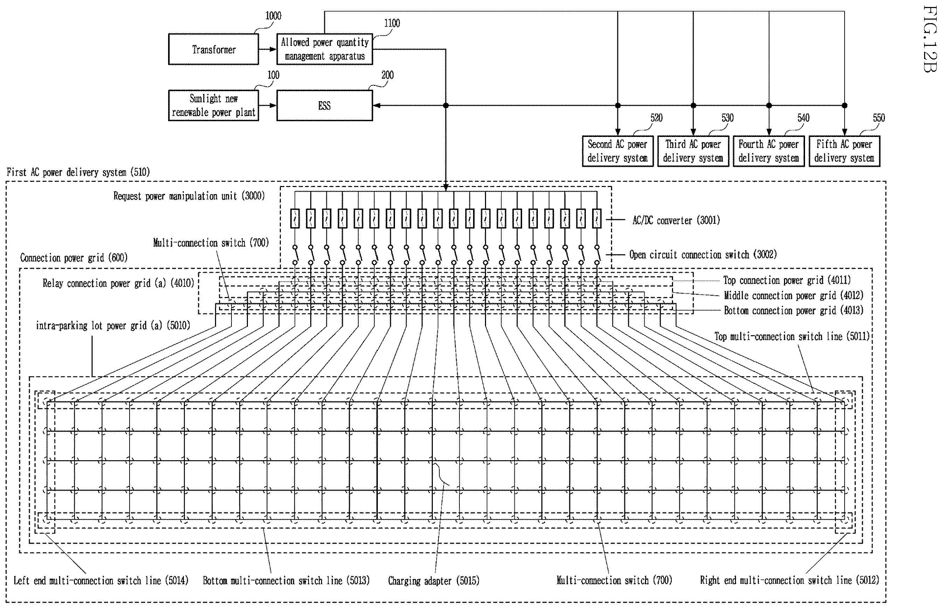

FIG. 12B represents a general structure from the transformer 1000 to the charging adapter 5015 at the place where the charging target vehicle 9000 has been disposed according to an embodiment of the present disclosure, as an example, as in FIG. 12A, and includes the transformer 1000, the allowed power quantity management apparatus 1100, the new renewable power plant 100 such as sunlight, the ESS 200, and the AC power delivery system 5500.

FIG. 2B is a diagram in which new renewable energy has been coupled in the drawing of FIG. 2A. The new renewable power plant 100, such as sunlight, may include new renewable power plants, such as solar energy generation and wind power generation. The solar energy generation is described as an example. Solar energy generation is a generation method of generating power by converting sunlight into DC electricity, and can generate power by using a solar panel to which several solar cells have been attached.

The solar panel has its output voltage determined depending on a construction of the solar cells and has a different current generated depending on the intensity of light. Power that is generated depending on the intensity of light is continuously changed. The charging system according to the present disclosure needs to supply a charging speed (requested power) requested by a charging wisher, and can supply a stable charging speed (requested power) by storing power generated by the solar energy generation in the ESS 200.

If power generated as in the solar energy generation is DC, the power is converted and stored in accordance with a charging voltage of the ESS 200 by using a DC/DC converter. If power generated as in the wind power generation is AC, the power is stored by using an AC/DC converter. In the example, the solar energy generation and the wind power generation have been described as examples, but the present disclosure is not limited to a corresponding generation method and various types of new renewable generation may be used.

The ESS 200 means an energy storage system, and may include several apparatuses for constructing the ESS 200, such as a battery, a battery management system (BMS), and a power management system (PMS). Apparatuses may be added or omitted if necessary.

Furthermore, the output voltage of the battery of the ESS 200 is DC, and may be supplied after being converted into AC power that is used in the AC power delivery system 5500 by using a DC/AC inverter. In order to charge the battery of the ESS 200 with power that is supplied by the transformer 1000, an AC/DC converter may be additionally constructed.

In the embodiment, solar energy generation has been described as an example, but the present disclosure is not limited to the generation method. Various types of new renewable generation methods, such as wind power, may be used.

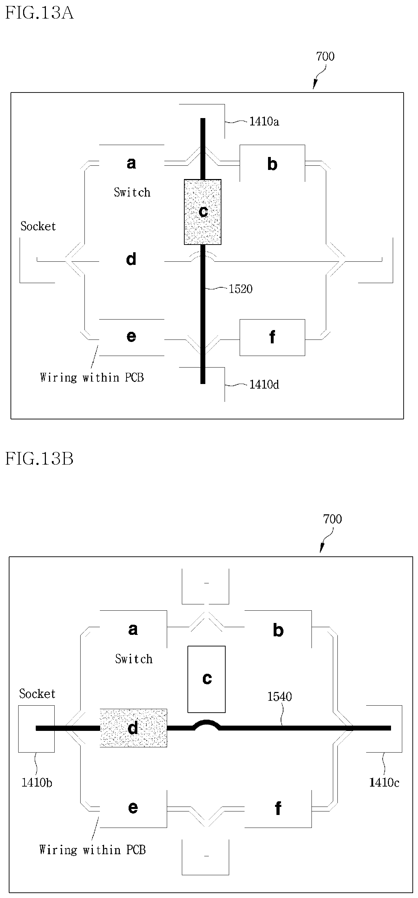

FIG. 13A is a diagram illustrating an example of an operation of the multi-connection switch, and illustrates an example in which the top-bottom (1520) path has been formed in the multi-connection switch 700. In FIGS. 13A to 13I, the multi-connection switch 700 consists of only switches and electrical wires for a description of an operation of the multi-connection switch 700.

Referring to FIG. 13A, in order to form the path, the top-bottom (1520) path is formed by making ON a switch c disposed between a top electrical wire 750 connected to a first socket 1410a and a bottom electrical wire 760 connected to a fourth socket 1410d. At this time, a switch a and a switch b, that is, other two switches connected to the top electrical wire 750, and a switch e and a switch f connected to the bottom electrical wire 760 maintain an OFF state.

When the states of other switches connected to the top electrical wire 750 become the ON state, a problem in that power supplied through the top electrical wire 750 may be distributed to several paths, not one path. Accordingly, other switches connected to the top electrical wire 750 in addition to the switch that is used to form the path maintain the OFF state.

FIG. 13B illustrates an example in which the left-right (1540) path has been formed in the multi-connection switch 700. In order to form the path, the left-right (1540) path is formed by making ON a switch d disposed between a left end electrical wire 770 connected to a second socket 1410b and a right end electrical wire 780 connected to a third socket 1410c. At this time, the switch a and the switch e connected to the left end electrical wire 770 and the switch b and the switch f connected to the right end electrical wire 780 maintain the OFF state.

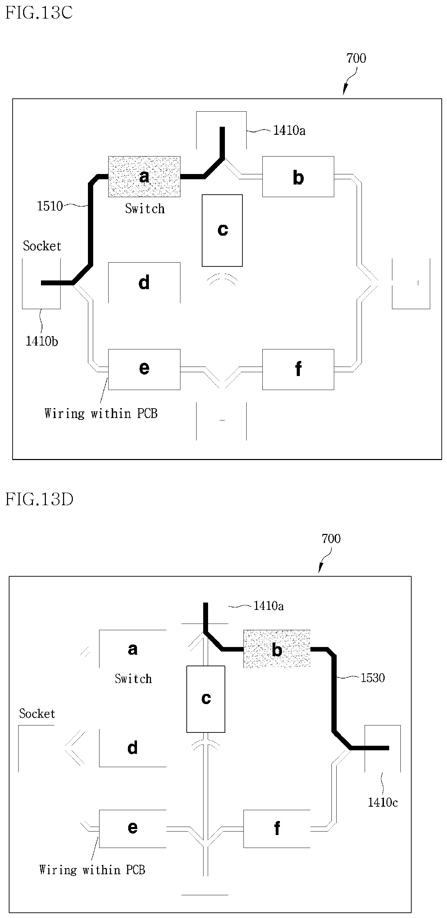

FIG. 13C illustrates an example in which the left-top (1510) path has been formed in the multi-connection switch 700. In order to form the path, the left-top (1510) path is formed by making ON the switch a disposed between the left end electrical wire 770 and the top electrical wire 750. At this time, the switch d and the switch e connected to the left end electrical wire 770 and the switch b and the switch c connected to the top electrical wire 750 maintain the OFF state.

FIG. 13D illustrates an example in which the right-top (1530) path has been formed in the multi-connection switch 700. In order to form the path, the right-top (1530) path is formed by making ON the switch b disposed between the right end electrical wire 780 and the top electrical wire 750. At this time, the switch d and the switch f connected to the right end electrical wire 780 and the switch a and the switch c connected to the top electrical wire 750 maintain the OFF state.

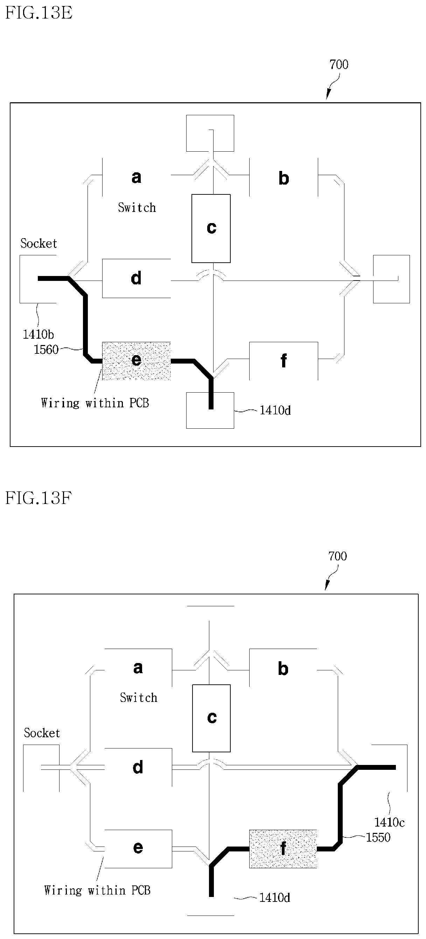

FIG. 13E illustrates an example in which the left-bottom (1560) path has been formed in the multi-connection switch 700. In order to form the path, the left-bottom (1560) path is formed by making ON the switch e disposed between the left end electrical wire 770 and the bottom electrical wire 760. At this time, the switch a and the switch d connected to the left end electrical wire 770 and the switch c and the switch f connected to the bottom electrical wire 760 maintain the OFF state.

FIG. 13F illustrates an example in which the right-bottom (1550) path has been formed in the multi-connection switch 700. In order to form the path, the right-bottom (1550) path is formed by making ON the switch f disposed between the right end electrical wire 780 and the bottom electrical wire 760. At this time, the switch b and the switch d connected to the right end electrical wire 780 and the switch c and the switch e connected to the bottom electrical wire 760 maintain the OFF state.

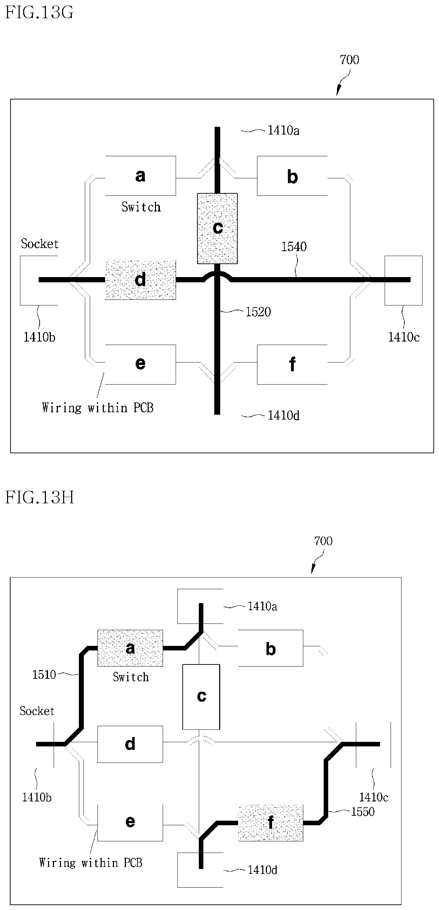

FIG. 13G illustrates an example in which two top-bottom (1520) and left-right (1540) paths that are not overlapped have been formed in the multi-connection switch 700. In order to form the top-bottom (1520) path, the switch c disposed between the top electrical wire 750 and the bottom electrical wire 760 is made ON. In order to form the left-right (1540) path, the switch d disposed between the left end electrical wire 770 and the right end electrical wire 780 is made ON. The switch a, the switch b, the switch e, and the switch f that are not used to form the paths maintain the OFF state.

FIG. 13H illustrates an example in which two left-top (1510) and right-bottom (1550) paths that are not overlapped have been formed in the multi-connection switch 700. In order to form the left-top (1510) path, the switch a disposed between the left end electrical wire 770 and the top electrical wire 750 is made ON. In order to form the right-bottom (1550) path, the switch f disposed between the right end electrical wire 780 and the bottom electrical wire 760 is made ON. The switch b, the switch c, the switch d, and the switch e that are not used to form the paths maintain the OFF state.

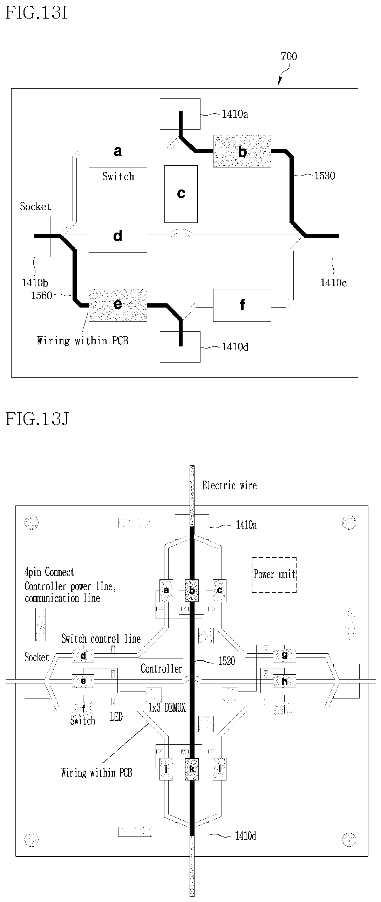

FIG. 13I illustrates an example in which two left-bottom (1560) and right-top (1530) paths that are not overlapped have been formed in the multi-connection switch 700. In order to form the left-bottom (1560) path, the switch e disposed between the left end electrical wire 770 and the bottom electrical wire 760 is made ON. In order to form the right-top (1530) path, the switch b disposed between the right end electrical wire 780 and the top electrical wire 750 is made ON. The switch a, the switch c, the switch d, and the switch f that are not used to form the paths maintain the OFF state.

FIG. 13J illustrates an example in which the top-bottom (1520) path has been formed in the multi-connection switch 700 in which the number of switches is greater than the number of paths. In order to form the path, a switch b and a switch k disposed between a top electrical wire 750 and a bottom electrical wire 760 are made ON. At this time, other switch a and switch c connected to the top electrical wire 750 and other switch j and switch l connected to the bottom electrical wire 760 maintain the OFF state.

Furthermore, in the forming of the path, a switch d and a switch j connected to a left end electrical wire 770 and switches g and i connected to the right end electrical wire 780 also maintain the OFF state. That is, the switches which may be connected to the top electrical wire 750 and the bottom electrical wire 760 maintain the OFF state.

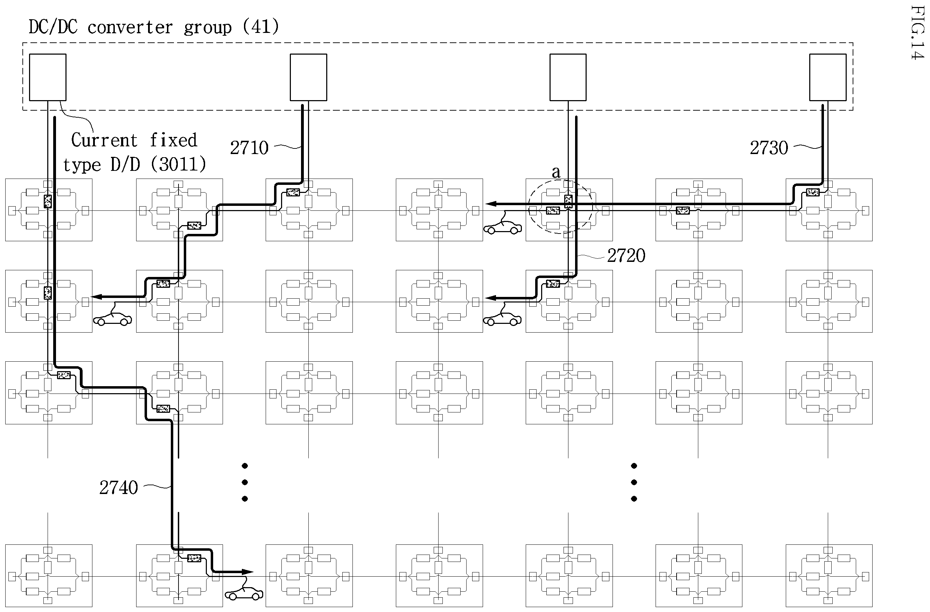

FIG. 14 is a diagram illustrating an example in which power is supplied from the DC/DC converter group 41 to the charging adapter 5015 by combining charging speeds in response to a request from a charging wisher.

The multi-connection switch 700 selects one electrical wire that is connected to the multi-connection switch 700 from the outside, in three paths, and connects the electrical wire to a switch. Accordingly, as the switches connected to the respective electrical wires are connected, basically, a total of the six paths of the top-bottom 1520, the left-right 1540, the left-top 1510, the left-bottom 1560, the right-top 1530, and the right-bottom 1550 can be formed.

In a common case, the multi-connection switch 700 forms the six paths. If two paths are not overlapped as in a of FIG. 14, two types of paths may be formed in the multi-connection switch 700.

As described above, selective charging connection paths 2710, 2720, 2730, and 2740 may be variously formed according to an operation of the switch 1600 within the multi-connection switch 700. Accordingly, a smaller number of DC/DC converters may correspond to a larger number of parking surfaces 80. More parking surfaces 80 can be used as parking zones in which electric vehicles can be charged.

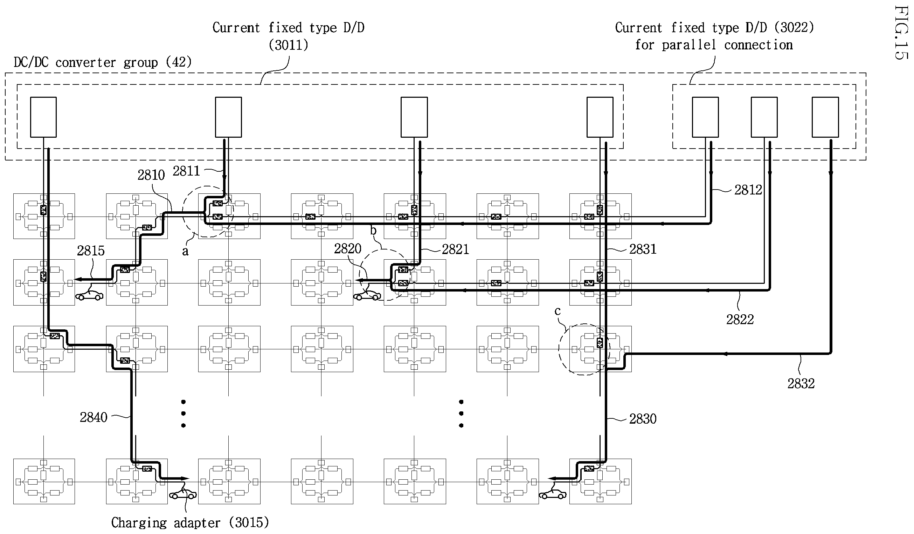

FIG. 15 is a diagram illustrating an example in which power is supplied from the DC/DC converter group 42 to the charging adapter 5015 by combining charging speed in response to a request from a charging wisher.

The multi-connection switch 700 selects one or more electrical wires that are connected to the multi-connection switch 700 from the outside, in three paths, and connects the electrical wire to a switch. Accordingly, as the switches connected to the electrical wires are connected, basically, a total of the six paths of the top-bottom 1520, the left-right 1540, the left-top 1510, the left-bottom 1560, the right-top 1530, and the right-bottom 1550 can be formed.

That is, in a common case, the multi-connection switch 700 forms the six paths, but the multi-connection switch 700 may form two connection paths that are not overlapped. According to circumstances, at least one multi-connection switches 700, among multiple multi-connection switches 700 that form paths, may form two connection paths that are not overlapped. Furthermore, the two connection paths may be connected to different DC/DC converters. As in FIG. 20B, the request power manipulation unit 3000 may include a plurality of first DC/DC converters 3011 and a plurality of second DC/DC converters 3022 which may be connected in parallel to the first DC/DC converters 3011. In this case, the two connection paths may include a connection path that is connected to one of the first DC/DC converters 3011 and a connection path that is connected to one of the second DC/DC converters 3022.

For example, the first DC/DC converter 3011 may be a current fixed type D/D. The second DC/DC converter 3012 may be a current fixed type D/D 3022 for a parallel connection to the current fixed type D/D 3011.

If charging speeds are combined in response to a request from a charging wisher as in FIG. 20B, as in a, b, and c of FIG. 15, two paths may be connected in parallel, thus combining charging speeds. In a, b, and c of FIG. 15, paths 2811, 2821, and 2831 connected to the current fixed type D/Ds 3011, respectively, and paths 2812, 2822, and 2832 connected to the current fixed type D/Ds 3022 for a parallel connection, respectively, are united. An adapter 3015 for charging an electric vehicle may be connected to the common paths 2810, 2820, and 2830.

Furthermore, when the charging speeds are combined, the charging speeds may be combined at an edge as in c, and the charging speeds may be combined inside as in a or b. This may be different depending on an optimal path when the current fixed type D/Ds 3011 and the current fixed type D/Ds 3022 for a parallel connection are combined.

**As** described above, the selective charging connection paths 2810, 2820, 2830, and 2840 can be variously formed according to an operation of the switch 1600 within the multi-connection switch 700. Accordingly, a smaller number of DC/DC converters may correspond to a larger number of parking surfaces 80. More parking surfaces 80 may be used as parking zones in which electric vehicles can be charged.

## Claims

1. A multi-connection switch comprising:
contacts in a plurality of directions, which are connected to a longitudinal conductor from an outside and are capable of electrical incoming and outgoing;
internal wirings formed of longitudinal conductors which mutually connect the contacts;
one or more switches configured to connect or disconnect any one part of the internal wirings and installed in a corresponding internal wiring; and
a control unit configured to make ON or OFF the switch.

2. The multi-connection switch of claim 1, wherein:
the longitudinal conductor is any one of an electrical wire or a bus bar, and
the contact is a socket.

3. The multi-connection switch of any one of claims 1 and 2, wherein:
one or more switches are installed in any one of the internal wirings, and
electricity that is input in any one of the plurality of directions is capable of being selectively output in any one direction other than the direction in which the electricity is input.

4. The multi-connection switch of any one of claims 1 to 3, wherein:
the contacts in the plurality of directions are contacts in four directions, and
the switch is relay.

5. The multi-connection switch of any one of claims 1, 2, or 4, wherein an electrical path along which six pieces of electricity are delivered is able to be formed.

6. The multi-connection switch of claim 5, wherein when switches on the internal wiring that connects the contacts in any two of the directions are made ON to form an electrical path, an electrical path by internal wiring that connects contacts in remaining two directions, except the contacts in the two directions, are simultaneously formed.

7. The multi-connection switch of any one of claim 4 or 6, further comprising a plurality of demultiplexers configured to operate the switches under a control of the control unit.

8. The multi-connection switch of any one of claim 1 or 4, further comprising an LED configured to display a connection path.

9. The multi-connection switch of claim 1, further comprising a communication line which transmits and receives signals to and from a main control apparatus.

10. A charging location-selective charging system comprising:
an AC/DC converting system configured to convert AC power into DC power;
a request power manipulation unit comprising DC/DC converters connected to an output stage of the AC/DC converting system and an open circuit connection switch connected to an output stage of each of the DC/DC converters;
charging adapters installed in at least some of parking spaces of a parking lot;
a power grid configured to connect the DC/DC converters and the charging adapters between the DC/DC converters and the charging adapters; and
a multi-connection switch connected to three or more electric wires of the power grid and configured to selectively form a connection path by connecting some electric wires, among the three or more electric wires,
wherein the multi-connection switch comprises:
contacts in a plurality of directions, which are connected to a longitudinal conductor from an outside and are capable of electrical incoming and outgoing;
internal wirings formed of longitudinal conductors which mutually connect the contacts;
one or more switches configured to connect or disconnect any one part of the internal wirings and installed in a corresponding internal wiring; and
a control unit configured to make ON or OFF the switch, and
wherein one or more switches are installed in any one of the internal wirings, and electricity that is input in any one of the plurality of directions is capable of being selectively output in any one direction other than the direction in which the electricity is input.

11. The charging location-selective charging system of claim 10, wherein the DC/DC converter, the power grid, and a charging adapter connected to an electric vehicle, among the charging adapters, are connected to the connection path that has been selectively formed, according to an operation of the multi-connection switch.

12. The charging location-selective charging system of claim 10, wherein the charging adapters have a greater number than the DC/DC converters.

13. The charging location-selective charging system of any one of claims 10 to 12, wherein the contacts of the multi-connection switch in the plurality of directions are contacts in four directions.

14. The charging location-selective charging system of any one of claims 10 to 13, wherein:
the multi-connection switch enables an electrical path along which six pieces of electricity are delivered to be formed, and
when switches on the internal wiring that connects the contacts in any two of the directions are made ON to form an electrical path, an electrical path by internal wiring that connects contacts in remaining two directions, except the contacts in the two directions, are simultaneously formed.
